# EUROPEAN PATENT APPLICATION

(11) **EP 4 712 734 A1**
(43) Date of publication of application: **18.03.2026**
(21) Application number: 25201882.5
(22) Date of filing: 12.09.2025
(51) Int. Cl.: H10F 10/14, H10F 10/16, H10F 10/165, H10F 10/166, H10F 77/20

(54) **BACK CONTACT SOLAR CELL AND PHOTOVOLTAIC MODULE**

(30) Priority: 12.09.2024 CN 202411278194; 30.10.2024 CN 202411534982
(71) Applicant: Longi Green Energy Technology Co., Ltd., Xi'an, Shaanxi 710100 (CN)
(72) Inventor: Li, Zhenguo, Xi'an City, 710100 (CN); Tong, Hongbo, Xi'an City, 710100 (CN); Sun, Zhanfeng, Xi'an City, 710100 (CN); Yu, Long, Xi'an City, 710100 (CN); Li, Jinyu, Xi'an City, 710100 (CN)
(74) Representative: Grünecker Patent- und Rechtsanwälte PartG mbB

(57) **Abstract**

The present application discloses a back contact solar cell and a photovoltaic module, and relates to the field of photovoltaic technologies, to cause a first dielectric passivation layer to have a relatively high field passivation effect and a relatively high chemical passivation effect on a first doped semiconductor part, and reduce field passivation impact of a second dielectric passivation layer on a second doped semiconductor part. The back contact solar cell includes a semiconductor substrate, a first doped semiconductor part, a second doped semiconductor part, a first dielectric passivation layer, and a second dielectric passivation layer. Each of the first dielectric passivation layer and the second dielectric passivation layer includes a first passivation sub-layer having a field passivation function. A conductivity type of the first doped semiconductor part is opposite to that of fixed charges of the first passivation sub-layer. Each of the first dielectric passivation layer and the second dielectric passivation layer further includes a second passivation sub-layer having a chemical passivation function.

## Description

The present application claims priority to Chinese Patent No. 202411278194.1, entitled "BACK CONTACT SOLAR CELL AND PHOTOVOLTAIC MODULE", and filed with the China National Intellectual Property Administration on September 12, 2024, which is incorporated herein by reference in their entireties.

### TECHNICAL FIELD

The present application relates to the field of photovoltaic technologies, and in particular, to a back contact solar cell and a photovoltaic module.

### BACKGROUND

A solar cell is an apparatus that can convert sun's light energy into electric energy. Specifically, when the solar cell is in an operating state, sunlight irradiates onto a semiconductor p-n junction of the solar cell to form new hole-electron pairs. Under an action of a built-in electric field of the p-n junction, photogenerated holes flow to a p-type region, and photogenerated electrons flow to an n-type region, so that a current can be generated when a circuit is powered on. A solar cell with a positive electrode and a negative electrode both being located on a back surface of the solar cell is a back contact solar cell. Compared with a double-sided contact solar cell, a front surface of the back contact solar cell is not blocked by metal electrodes, so that a light receiving surface of the back contact solar cell has higher light utilization. Therefore, the back contact solar cell has a higher short-circuit current and higher photoelectric conversion efficiency, and therefore is one of existing technical directions for realizing efficient crystalline silicon solar cells. In addition, the foregoing back contact solar cell may include a surface passivation layer having both a field passivation function and a chemical passivation function, to improve a passivation effect on a side having the surface passivation layer in the back contact solar cell.

However, in the existing back contact solar cell including the foregoing surface passivation layer having both the field passivation function and the chemical passivation function, the surface passivation layer cannot satisfy both a passivation requirement of a P region and a passivation requirement of an N region, resulting in poor working performance of the solar cell.

### SUMMARY

An objective of the present application is to provide a back contact solar cell and a photovoltaic module, to reduce, for a case that a conductivity type of a first doped semiconductor part is different from that of a second doped semiconductor part and a first dielectric passivation layer has a relatively high field passivation effect and a relatively high chemical passivation effect on the first doped semiconductor part, field passivation impact of a second dielectric passivation layer on the second doped semiconductor part, thereby improving working efficiency of the back contact solar cell.

To achieve the objective, according to a first aspect, the present application provides a back contact solar cell. The back contact solar cell includes: a semiconductor substrate, a first doped semiconductor part, a second doped semiconductor part, a first dielectric passivation layer, and a second dielectric passivation layer. A conductivity type of the first doped semiconductor part is opposite to a conductivity type of the second doped semiconductor part. Each of the first dielectric passivation layer and the second dielectric passivation layer includes a first passivation sub-layer having a field passivation function. The conductivity type of the first doped semiconductor part is opposite to a conductivity type of fixed charges of the first passivation sub-layer. The semiconductor substrate includes a first surface and a second surface opposite to the first surface. Along a direction parallel to the first surface, the first doped semiconductor part and the second doped semiconductor part are alternately distributed on the first surface. The first dielectric passivation layer covers a side of the first doped semiconductor part facing away from the semiconductor substrate, and the second dielectric passivation layer covers a side of the second doped semiconductor part facing away from the semiconductor substrate. A thickness of the first passivation sub-layer included in the first dielectric passivation layer is greater than a thickness of the first passivation sub-layer included in the second dielectric passivation layer. Each of the first dielectric passivation layer and the second dielectric passivation layer further includes a second passivation sub-layer having a chemical passivation function. The second passivation sub-layer is disposed on a side of the first passivation sub-layer facing away from the semiconductor substrate. A material of the second passivation sub-layer included in the first dielectric passivation layer is different from a material of the first passivation sub-layer included in the first dielectric passivation layer. A material of the second passivation sub-layer included in the second dielectric passivation layer is different from a material of the first passivation sub-layer included in the second dielectric passivation layer.

When the foregoing technical solution is used, the conductivity type of the first doped semiconductor part is opposite to the conductivity type of the second doped semiconductor part, and the conductivity type of the first doped semiconductor part is opposite to the conductivity type of the fixed charges of the first passivation sub-layer that covers the side of the first doped semiconductor part facing away from the semiconductor substrate and the conductivity type of the fixed charges of the first passivation sub-layer that covers the side of the second doped semiconductor part facing away from the semiconductor substrate. In addition, the first passivation sub-layers included in the first dielectric passivation layer and the second dielectric passivation layer not only have a chemical passivation function, but also have a field passivation function. In addition, the first passivation sub-layer included in the first dielectric passivation layer may sense, on a side close to the first doped semiconductor part, charges having a conductivity type opposite to that of the first doped semiconductor part, and a side of the first passivation sub-layer included in the first dielectric passivation layer facing away from the first doped semiconductor part has charges having a same conductivity type as that of the first doped semiconductor part, so that an electric field is generated at the first passivation sub-layer included in the first dielectric passivation layer. Because the conductivity type of the fixed charges of the first passivation sub-layer included in the first dielectric passivation layer is opposite to the conductivity type of the dopant in the first doped semiconductor part, the electric field can shield minority carriers, to enhance a carrier collection capability and a carrier separation capability of the first doped semiconductor part. On the contrary, an electric field generated in the first passivation sub-layer included in the second dielectric passivation layer forms a reverse field at the second doped semiconductor part whose fixed charges have the same conductivity type as that of the first passivation sub-layer. In this case, the field passivation function of the second dielectric passivation layer has a weakening effect on the electric field of the second doped semiconductor part, and affects a carrier collection capability of the second doped semiconductor part.

In a possible implementation solution, a thickness of the first passivation sub-layer included in the first dielectric passivation layer is greater than a thickness of the first passivation sub-layer included in the second dielectric passivation layer. The field passivation effect of the first passivation sub-layer is in direct proportion to the thickness of the first passivation sub-layer. Based on this, when the thickness of the first passivation sub-layer included in the first dielectric passivation layer is greater than the thickness of the first passivation sub-layer included in the second dielectric passivation layer, the first passivation sub-layer disposed on the side of the second doped semiconductor part facing away from the semiconductor substrate has a relatively small thickness. In this case, the first passivation sub-layer included in the second dielectric passivation layer and having a relatively small thickness can weaken the effect of the first passivation sub-layer on the reverse field of the second doped semiconductor part, so that the second doped semiconductor part has relatively high carrier collection efficiency. In addition, due to existence of both the first passivation sub-layer and the second passivation sub-layer included in the second dielectric passivation layer, chemical passivation can be performed on the surface of the second doped semiconductor part, to reduce surface defects of the second doped semiconductor part. In addition, the first passivation sub-layer disposed on the side of the first doped semiconductor part facing away from the semiconductor substrate has a relatively large thickness. In this case, the first passivation sub-layer having a relatively large thickness has a higher field passivation effect of a co-directional field on the first doped semiconductor part, to enhance a carrier collection capability of the first doped semiconductor part and reduce surface defects of the first doped semiconductor part. It can be seen that, in the back contact solar cell provided in the present application, for a case that the conductivity type of the first doped semiconductor part is different from that of the second doped semiconductor part and the first dielectric passivation layer has a relatively high field passivation effect and a relatively high chemical passivation effect on the first doped semiconductor part, field passivation impact of the second dielectric passivation layer on the second doped semiconductor part is reduced. In addition, a passivation requirement for doped semiconductor parts of two different conductivity types is satisfied, so that each of a part corresponding to the first doped semiconductor part and a part corresponding to the second doped semiconductor part has a relatively low carrier recombination rate and a relatively high carrier separation capability on a side of a back surface of the back contact solar cell, thereby improving the working performance of the back contact solar cell.

In a possible implementation solution, under a same test condition, a PL luminance value of a part on a back surface of the back contact solar cell corresponding to the second doped semiconductor part is greater than a PL luminance value of a part on the back surface of the back contact solar cell corresponding to the first doped semiconductor part.

When the foregoing technical solution is used, the PL luminance value refers to luminance of light emitted by the solar cell under a lighting condition. The magnitude of the PL luminance value is related to passivation performance of a test part, and represents a comprehensive passivation effect of all film layers at a position corresponding to the first doped semiconductor part or at a position corresponding to the second doped semiconductor part, for example, a comprehensive passivation effect of tunneling passivation layers, doped semiconductor parts, and dielectric passivation layers. Specifically, under a same test condition, a larger PL luminance value indicates higher passivation performance of the part, and a smaller PL luminance value indicates lower passivation performance of the part. Based on this, when the PL luminance value corresponding to the part corresponding to the second doped semiconductor part is greater than the PL luminance value corresponding to the part corresponding to the first doped semiconductor part on the side of the back surface of the back contact solar cell, this case represents a comprehensive passivation effect of all film layers at a position corresponding to the first doped semiconductor part or at a position corresponding to the second doped semiconductor part, for example, a comprehensive passivation effect of tunneling passivation layers, doped semiconductor parts, and dielectric passivation layers. In the side of the back surface of the back contact solar cell provided in the present application, the passivation performance of the part corresponding to the second doped semiconductor part is higher than the passivation performance of the part corresponding to the first doped semiconductor part. In addition, PL luminance values of two regions can also indirectly reflect chemical passivation effects, that is, the chemical passivation effect of the second dielectric passivation layer is greater than the chemical passivation effect of the first dielectric passivation layer. A comprehensive passivation effect corresponding to the second doped semiconductor part is enhanced through the chemical passivation, and a difference between the part corresponding to the first doped semiconductor part and the part corresponding to the second doped semiconductor part in terms of the passivation effect on the side of the back surface of the back contact solar cell is reduced. In addition, a passivation requirement for doped semiconductor parts of two different conductivity types is satisfied, so that each of a part corresponding to the first doped semiconductor part and a part corresponding to the second doped semiconductor part has a relatively low carrier recombination rate and a relatively high carrier separation capability on a side of a back surface of the back contact solar cell, thereby improving the working performance of the back contact solar cell.

In a possible implementation solution, the thickness of the first passivation sub-layer is greater than or equal to 2 nm and less than or equal to 15 nm. In this case, that the thickness of the first passivation sub-layer falls within the foregoing range can avoid that the first passivation sub-layer has a relatively low passivation effect because of an excessively small thickness of the first passivation sub-layer, thereby ensuring that the sides of the first doped semiconductor part and the second doped semiconductor part facing away from the semiconductor substrate have a relatively low carrier recombination rate; and can further avoid that the first passivation sub-layer greatly affects the carrier collection efficiency of the second doped semiconductor part because of an excessively large thickness of the first passivation sub-layer, thereby ensuring high conversion efficiency of the back contact solar cell.

In a possible implementation solution, the thickness of the first passivation sub-layer included in the first dielectric passivation layer is greater than or equal to 4 nm and less than or equal to 15 nm. In this case, the relatively large thickness of the first passivation sub-layer included in the first dielectric passivation layer can further enhance a field passivation effect of the first passivation sub-layer included in the first dielectric passivation layer on the first doped semiconductor part, to help further reduce a differentiation degree between the part corresponding to the first doped semiconductor part and the part corresponding to the second doped semiconductor part in terms of a passivation effect on the side of the back surface of the back contact solar cell, thereby further improving the working performance of the back contact solar cell.

In a possible implementation solution, the thickness of the first passivation sub-layer included in the second dielectric passivation layer is greater than or equal to 2 nm and less than or equal to 8 nm.

When the foregoing technical solution is used, the thickness of the first passivation sub-layer included in the second dielectric passivation layer falls within the foregoing range, which helps avoid a case that a comprehensive passivation effect of the first passivation sub-layer included in the second dielectric passivation layer on the second doped semiconductor part is relatively low due to a relatively small thickness of the first passivation sub-layer included in the second dielectric passivation layer, to ensure that a side of the second doped semiconductor part facing away from the semiconductor substrate has relatively few surface defects; and further helps avoid a case that a degree by which the electric field of the second doped semiconductor part is weakened by the field passivation effect of the first passivation sub-layer included in the second dielectric passivation layer is relatively high because of a relatively large thickness of the first passivation sub-layer included in the second dielectric passivation layer, thereby ensuring a relatively high carrier collection efficiency of the second doped semiconductor part.

In a possible implementation solution, a thickness of the second passivation sub-layer included in the first dielectric passivation layer is less than a thickness of the second passivation sub-layer included in the second dielectric passivation layer.

When the foregoing technical solution is used, the second passivation sub-layer included in the second dielectric passivation layer having a relatively large thickness (relative to the second passivation sub-layer included in the first dielectric passivation layer) is disposed on the first passivation sub-layer included in the second dielectric passivation layer having a relatively small thickness (relative to the first passivation sub-layer included in the first dielectric passivation layer), which helps compensate for, by using the second passivation sub-layer included in the second dielectric passivation layer having a relatively large thickness, weakening of the field passivation effect of the first passivation sub-layer included in the second dielectric passivation layer on the side of the second doped semiconductor part facing away from the semiconductor substrate, thereby further reducing the quantity of surface defects on the side of the second doped semiconductor part facing away from the semiconductor substrate, and helps reduce a differentiation between the part corresponding to the first doped semiconductor part and the part corresponding to the second doped semiconductor part in terms of a passivation effect on the side of the back surface of the back contact solar cell, thereby improving the working performance of the back contact solar cell.

In a possible implementation solution, a difference between a thickness of the second passivation sub-layer included in the second dielectric passivation layer and a thickness of the second passivation sub-layer included in the first dielectric passivation layer is greater than or equal to 0.5 nm and less than or equal to 5 nm.

When the foregoing technical solution is used, that the difference between the thickness of the second passivation sub-layer included in the second dielectric passivation layer and the thickness of the second passivation sub-layer included in the first dielectric passivation layer falls within the foregoing range can avoid that because the difference is relatively small, the second passivation sub-layer included in the second dielectric passivation layer and the second passivation sub-layer included in the first dielectric passivation layer have approximately the same chemical passivation effect, thereby ensuring that the difference between the chemical passivation effects of the parts on the side of the back surface and respectively corresponding to the first doped semiconductor part and the second doped semiconductor part can be compensated for by using the second passivation sub-layer included in the second dielectric passivation layer; and can further avoid that because the difference is relatively large, the second passivation sub-layer included in the first dielectric passivation layer has an excessively low passivation effect due to an excessively small thickness of the second passivation sub-layer included in the first dielectric passivation layer, or a use amount of consumables is relatively high because of an excessively large thickness of the second passivation sub-layer included in the second dielectric passivation layer, thereby helping control manufacturing costs of the solar cell.

In a possible implementation solution, a thickness of the second passivation sub-layer is greater than or equal to 50 nm and less than or equal to 160 nm. In this case, that the thickness of the second passivation sub-layer falls within the foregoing range helps avoid that the second passivation sub-layer has a relatively weak passivation effect because of a small thickness of the first passivation sub-layer, thereby ensuring a relatively low carrier recombination rate on the side of the back surface of the back contact solar cell, and improving the working performance of the back contact solar cell; and can further avoid that a use amount of consumables of the second passivation sub-layer is relatively large because of a large thickness of the second passivation sub-layer, thereby helping control manufacturing costs of the back contact solar cell.

In a possible implementation solution, a thickness of the first dielectric passivation layer is less than a thickness of the second dielectric passivation layer. In this case, because the thickness of the first passivation sub-layer included in the first dielectric passivation layer is greater than the thickness of the second passivation sub-layer included in the second dielectric passivation layer, that the thickness of the first dielectric passivation layer is less than the thickness of the second dielectric passivation layer helps cause the thickness of the second passivation sub-layer included in the first dielectric passivation layer to be less than the thickness of the second passivation sub-layer included in the second dielectric passivation layer. Based on this, for an application principle of the beneficial effect that the thickness of the first dielectric passivation layer is less than the thickness of the second dielectric passivation layer, refer to the foregoing application principle of the beneficial effect that the thickness of the second passivation sub-layer included in the first dielectric passivation layer is less than the thickness of the second passivation sub-layer included in the second dielectric passivation layer. Details are not described herein again.

In a possible implementation solution, a ratio of a thickness of the first dielectric passivation layer to a thickness of the second dielectric passivation layer is greater than or equal to 0.9 and less than or equal to 1.1.

When the foregoing technical solution is used, when the ratio of the thickness of the first dielectric passivation layer to the thickness of the second dielectric passivation layer is greater than or equal to 0.9 and less than or equal to 1.1, the thickness of the first dielectric passivation layer disposed on the side of the first doped semiconductor part facing away from the semiconductor substrate is approximately the same as the thickness of the second dielectric passivation layer disposed on the side of the second doped semiconductor part facing away from the semiconductor substrate, which helps cause the first dielectric passivation layer and the second dielectric passivation layer to have approximately the same comprehensive passivation effect, thereby helping further reduce a differentiation between the part corresponding to the first doped semiconductor part and the part corresponding to the second doped semiconductor part in terms of a passivation effect on the side of the back surface of the back contact solar cell.

In a possible implementation solution, a thickness of the first dielectric passivation layer and/or the second dielectric passivation layer is greater than or equal to 52 nm and less than or equal to 175 nm.

When the foregoing technical solution is used, when the thickness of the first dielectric passivation layer and/or the second dielectric passivation layer falls within the foregoing range, a moderate thickness of the first dielectric passivation layer and/or the second dielectric passivation layer avoids that a passivation effect of the first dielectric passivation layer and/or the second dielectric passivation layer is relatively weak due to a relatively small thickness value, and can further avoid that a distribution density of micro-structures in the first dielectric passivation layer and/or the second dielectric passivation layer is relatively large or a use amount of consumables is relatively high due to a relatively large thickness, thereby ensuring a relatively high operation efficiency of the back contact solar cell, and helping control manufacturing costs of the solar cell.

In a possible implementation solution, a ratio of a refractive index of the first dielectric passivation layer to a refractive index of the second dielectric passivation layer is greater than or equal to 0.9 and less than or equal to 1.1; and/or a refractive index of the first dielectric passivation layer and/or the second dielectric passivation layer is greater than or equal to 2.0 and less than or equal to 2.2.

When the foregoing technical solution is used, when the ratio of the refractive index of the first dielectric passivation layer to the refractive index of the second dielectric passivation layer is greater than or equal to 0.9 and less than or equal to 1.1, the refractive index of the first dielectric passivation layer and the refractive index of the second dielectric passivation layer are approximately the same, which helps cause the part corresponding to the first dielectric passivation layer and the part corresponding to the second dielectric passivation layer on the side of the back surface of the back contact solar cell to have approximately the same light refracting function, to help achieve uniform light absorption and help ensure balance between electrons and holes. In addition, when the refractive index of the first dielectric passivation layer and/or the second dielectric passivation layer falls within the foregoing range, the refractive index of the first dielectric passivation layer and/or the second dielectric passivation layer has a relatively high refracting effect on light, which helps cause more light to be set into the semiconductor substrate by using the refractive index of the first dielectric passivation layer and/or the second dielectric passivation layer, thereby improving a bifacial ratio of the solar cell.

In a possible implementation solution, the first passivation sub-layer included in the first dielectric passivation layer is an aluminum oxide layer, and under a test condition in which an exposure time is 0.2s and a light intensity is 1 sun, a PL luminance value corresponding to the side of the first passivation sub-layer included in the first dielectric passivation layer that faces away from the semiconductor substrate is greater than or equal to 5000, and/or a PL luminance value corresponding to the side of the first passivation sub-layer included in the second dielectric passivation layer that faces away from the semiconductor substrate is greater than or equal to 16500.

When the foregoing technical solution is used, the aluminum oxide layer includes a large quantity of negative oxygen ions, and can form fixed negative charges with a relatively large density at an interface between the aluminum oxide layer and the first doped semiconductor part, to generate a built-in electric field having a function of shielding minority carriers, thereby improving the carrier collection efficiency of the first doped semiconductor part and enhancing the carrier separation capability of the first doped semiconductor part. Secondly, under the test condition in which the exposure time is 0.2s and the light intensity is 1 sun, when the PL luminance value corresponding to the side of the first passivation sub-layer included in the first dielectric passivation layer that faces away from the semiconductor substrate is greater than or equal to 5000, the existence of the first passivation sub-layer included in the first dielectric passivation layer having a relatively large thickness improves a field passivation effect on the first doped semiconductor part, to help further reduce a differentiation between the part corresponding to the first doped semiconductor part and the part corresponding to the second doped semiconductor part in terms of a passivation effect on the side of the back surface of the back contact solar cell. In addition, that the corresponding PL luminance value of the side of the first passivation sub-layer included in the second dielectric passivation layer that faces away from the semiconductor substrate falls within the foregoing range can reduce, by performing chemical passivation and/or field passivation on the second doped semiconductor part by using the first passivation sub-layer included in the second dielectric passivation layer, impact of a field passivation function of the first passivation sub-layer on the carrier collection efficiency of the second doped semiconductor part as much as possible, to ensure that the second doped semiconductor part has a relatively high carrier separation capability, thereby helping further reduce a differentiation between the part corresponding to the first doped semiconductor part and the part corresponding to the second doped semiconductor part in terms of a passivation effect on the side of the back surface of the back contact solar cell.

In a possible implementation solution, when each of the first passivation sub-layers included in the first dielectric passivation layer and the second dielectric passivation layer is an aluminum oxide layer, a ratio of a PL luminance value corresponding to the side of the first passivation sub-layer included in the second dielectric passivation layer that faces away from the semiconductor substrate to a PL luminance value corresponding to the side of the first passivation sub-layer included in the first dielectric passivation layer that faces away from the semiconductor substrate is greater than or equal to 2.5 and less than or equal to 3.4. In this case, compared with a ratio (which is roughly greater than or equal to 3 and less than or equal to 4) of the PL luminance value corresponding to the side of the second doped semiconductor part facing away from the semiconductor substrate to the PL luminance value corresponding to the side of the first doped semiconductor part facing away from the semiconductor substrate, when the ratio of the PL luminance value corresponding to the side of the first passivation sub-layer included in the second dielectric passivation layer that faces away from the semiconductor substrate to the PL luminance value corresponding to the side of the first passivation sub-layer included in the first dielectric passivation layer that faces away from the semiconductor substrate is greater than or equal to 2.5 and less than or equal to 3.4, the ratio between the foregoing PL luminance values is relatively small, that is, existence of the first passivation sub-layers included in the first dielectric passivation layer and the second dielectric passivation layer helps reduce a differentiation between the part corresponding to the first doped semiconductor part and the part corresponding to the second doped semiconductor part in terms of a passivation effect on the side of the back surface of the back contact solar cell, and a passivation requirement for doped semiconductor parts of two different conductivity types is satisfied.

In a possible implementation solution, a surface reflectance of the side of the first doped semiconductor part facing away from the semiconductor substrate is greater than a surface reflectance of the side of the second doped semiconductor part facing away from the semiconductor substrate.

When the foregoing technical solution is used, it may be understood that, the surface reflectance is inversely proportional to a specific surface area. A larger specific surface area indicates a higher surface light trapping effect and a lower surface reflectance. Secondly, the specific surface area is in direct proportion to a surface roughness, and a larger specific surface area indicates a higher surface roughness. Based on this, when the surface reflectance of the side of the first doped semiconductor part facing away from the semiconductor substrate is greater than the surface reflectance of the side of the second doped semiconductor part facing away from the semiconductor substrate, the surface roughness of the side of the first doped semiconductor part facing away from the semiconductor substrate is relatively small, and the surface roughness of the side of the second doped semiconductor part facing away from the semiconductor substrate is relatively large. However, under a same condition, deposition thicknesses of film layers of the first passivation sub-layer included in the first dielectric passivation layer and the first passivation sub-layer included in the second dielectric passivation layer are inversely proportional to the roughness of the surface on which the first passivation sub-layers are deposited. Therefore, this case that the surface roughness of the side of the first doped semiconductor part facing away from the semiconductor substrate is relatively small helps, when the first passivation sub-layer included in the first dielectric passivation layer and the first passivation sub-layer included in the second dielectric passivation layer are manufactured under a same process condition, to form, on the side of the first doped semiconductor part facing away from the semiconductor substrate, the first passivation sub-layer included in the first dielectric passivation layer and having a relatively large thickness, thereby improving a field passivation effect of the first passivation sub-layer included in the first dielectric passivation layer, and to form, on the side of the second doped semiconductor part facing away from the semiconductor substrate, the first passivation sub-layer included in the second dielectric passivation layer and having a relatively small thickness, thereby reducing a field passivation effect of the first passivation sub-layer included in the second dielectric passivation layer, reducing the ratio between the PL luminance values of the part corresponding to the first doped semiconductor part and the part corresponding to the second doped semiconductor part on the side of the back surface of the solar cell, to reduce a differentiation degree in terms of passivation. In addition, this case that the surface roughness of the side of the second doped semiconductor part facing away from the semiconductor substrate is relatively large helps to form, on the side of the second doped semiconductor part facing away from the semiconductor substrate, the first passivation sub-layer included in the second dielectric passivation layer and having a relatively small thickness, thereby reducing impact of the field passivation effect of the first passivation sub-layer included in the second dielectric passivation layer on carrier collection efficiency of the second doped semiconductor part.

In a possible implementation solution, when a surface reflectance of the side of the first doped semiconductor part facing away from the semiconductor substrate is greater than a surface reflectance of the side of the second doped semiconductor part facing away from the semiconductor substrate, a side of the first doped semiconductor part facing away from the semiconductor substrate has a first texture structure, and a side of the second doped semiconductor part facing away from the semiconductor substrate has a second texture structure. A one-dimensional size of the first texture structure is different from a one-dimensional size of the second texture structure.

When the foregoing technical solution is used, the one-dimensional sizes of the first texture structure and the second texture structure may be adjusted, so that the side surface, on which the first texture structure is formed, of the first doped semiconductor part facing away from the semiconductor substrate has a larger reflectance and a lower surface roughness, which helps to form, on the side of the first doped semiconductor part facing away from the semiconductor substrate, the first passivation sub-layer included in the first dielectric passivation layer and having a relatively large thickness, thereby improving a field passivation effect of the first passivation sub-layer included in the first dielectric passivation layer, and to form, on the side of the second doped semiconductor part facing away from the semiconductor substrate, the first passivation sub-layer included in the second dielectric passivation layer and having a relatively small thickness, thereby reducing a field passivation effect of the first passivation sub-layer included in the second dielectric passivation layer, reducing the ratio between the PL luminance values of the part corresponding to the first doped semiconductor part and the part corresponding to the second doped semiconductor part on the side of the back surface of the solar cell, to reduce a differentiation degree in terms of passivation. In addition, the side surface, on which the second texture structure is formed, of the second doped semiconductor part facing away from the semiconductor substrate has a smaller reflectance and a higher surface roughness, which helps to form, on the side of the second doped semiconductor part facing away from the semiconductor substrate, the first passivation sub-layer included in the second dielectric passivation layer and having a relatively small thickness, thereby reducing impact of the field passivation effect of the first passivation sub-layer included in the second dielectric passivation layer on carrier collection efficiency of the second doped semiconductor part.

In a possible implementation solution, when the first doped semiconductor part is a P-type doped semiconductor part, and the second doped semiconductor part is an N-type doped semiconductor part, a doping concentration of a dopant in the first doped semiconductor part is less than a doping concentration of a dopant in the second doped semiconductor part, and/or a thickness of the first doped semiconductor part is greater than a thickness of the second doped semiconductor part.

When the foregoing technical solution is used, as described above, the first passivation sub-layer included in the first dielectric passivation layer may form a superimposed field at the first doped semiconductor part, thereby improving carrier collection efficiency of the first doped semiconductor part. The first passivation sub-layer included in the second dielectric passivation layer forms a reverse field at the second doped semiconductor part, affecting carrier collection efficiency of the second doped semiconductor part. Based on this, when the doping concentration of the dopant in the second doped semiconductor part is relatively large, the electric field generated by the second doped semiconductor part has a larger strength, so that a difference between the carrier collection capabilities of the second doped semiconductor part and the first doped semiconductor part caused by a suppression effect of the reverse field formed by the field passivation function of the first passivation sub-layer included in the second dielectric passivation layer can be compensated for, thereby facilitating uniform collection of carriers of different conductivity types.

In a possible implementation solution, when the first doped semiconductor part is a P-type doped semiconductor part, and the second doped semiconductor part is an N-type doped semiconductor part, a thickness of the first doped semiconductor part is greater than a thickness of the second doped semiconductor part. This case helps to increase a field passivation effect of the first doped semiconductor part on the corresponding regional surface of the semiconductor substrate, which can further reduce the ratio between the PL luminance values of the part corresponding to the first doped semiconductor part and the part corresponding to the second doped semiconductor part on the side of the back surface of the solar cell, to reduce a differentiation degree in terms of passivation.

In a possible implementation solution, the first passivation sub-layer included in the first dielectric passivation layer includes a hydrogen-containing passivation layer, and a local region of the hydrogen-containing passivation layer has a micro-structure.

When the foregoing technical solution is used, the existence of the foregoing micro-structure indicates that the content of hydrogen ions in the hydrogen-containing passivation layer is sufficient, so that the hydrogen-containing passivation layer has a higher hydrogen passivation effect on a corresponding doped semiconductor layer, thereby further reducing surface defects of the corresponding doped semiconductor layer. Specifically, at least one micro-structure may be a structure that is bulged in a direction away from the semiconductor substrate. In this case, an accommodating space that is formed by bulging exists between the hydrogen-containing passivation layer having the micro-structure and the corresponding doped semiconductor part, and the accommodating space has hydrogen gas that generates the bulged structure, thereby further reducing surface defects of the corresponding doped semiconductor layer. Secondly, the hydrogen gas in the bulged structure can further continuously provide hydrogen ions in a subsequent manufacturing process or solar cell working process, so as to achieve continuous hydrogen passivation on the corresponding doped semiconductor layer, thereby helping to improve the yield of the solar cell and prolong the service life of the solar cell.

In addition, the at least one micro-structure may alternatively be a micro-structure that is sunken or bulged in the middle and that has a cyclonic shape at an edge (in this case, the micro-structure presents, for example, a shape formed by rotation of a liquid around a straight or curved axis along a direction), indicating that the content of hydrogen in the hydrogen-containing passivation layer is higher, so that a sufficient amount of hydrogen ions is used without hydrogen passivation, and film explosion occurs in the micro-structure after hydrogen ions escape from the hydrogen-containing passivation layer. Based on this, when the hydrogen-containing passivation layer includes such a micro-structure, the hydrogen-containing passivation layer has a higher hydrogen passivation effect on the corresponding doped semiconductor layer. In addition, after film explosion occurs, a bumpy micro-structure can be formed on a side of the hydrogen-containing passivation layer facing away from the semiconductor substrate, which helps to reduce the reflectance of the side of the hydrogen-containing passivation layer facing away from the semiconductor substrate, and improve a light trapping effect of the hydrogen-containing passivation layer.

In a possible implementation solution, when each of the first passivation sub-layer included in the first dielectric passivation layer and the first passivation sub-layer included in the second dielectric passivation layer includes the hydrogen-containing passivation layer, a distribution density of the micro-structure in the first passivation sub-layer included in the first dielectric passivation layer is greater than a distribution density of the micro-structure in the first passivation sub-layer included in the second dielectric passivation layer.

When the foregoing technical solution is used, it may be understood that, a larger thickness and/or higher compactness of the hydrogen-containing passivation layer indicates a higher content of hydrogen in the hydrogen-containing passivation layer, and is more likely to form the foregoing micro-structure due to escape of hydrogen after the hydrogen-containing passivation layer is exposed to heat. Based on this, a case that the distribution density of the micro-structure in the first passivation sub-layer included in the first dielectric passivation layer is greater than the distribution density of the micro-structure in the first passivation sub-layer included in the second dielectric passivation layer helps to enable the first passivation sub-layer included in the first dielectric passivation layer to have a larger thickness and/or higher film layer compactness (compared with the first passivation sub-layer included in the second dielectric passivation layer), to ensure that the first passivation sub-layer included in the first dielectric passivation layer has a higher field passivation effect on a first doped semiconductor layer; and helps to enable the first passivation sub-layer included in the second dielectric passivation layer to have a relatively small thickness and/or a relatively low film layer compactness, so as to reduce impact of the field passivation function of the first passivation sub-layer included in the second dielectric passivation layer on carrier collection efficiency of a second doped semiconductor layer, thereby ensuring relatively high operation efficiency of the back contact solar cell.

In a possible implementation solution, a size of the at least one micro-structure is greater than or equal to 10 µm and less than or equal to 20 µm.

When the foregoing technical solution is used, as described above, when the hydrogen-containing passivation layer has the foregoing micro-structure, it indicates that the hydrogen-containing passivation layer has a sufficient content of hydrogen ions, so that the hydrogen-containing passivation layer has a relatively high chemical passivation effect on a corresponding doped semiconductor layer. In addition, due to existence of the foregoing micro-structure, at least some regions of the hydrogen-containing passivation layer at the micro-structure cannot be in contact with the corresponding doped semiconductor layer, that is, the at least some regions of the hydrogen-containing passivation layer at the micro-structure cannot perform passivation treatment on the corresponding doped semiconductor layer. Based on this, that the size of the micro-structure falls within the foregoing range can avoid that the content of hydrogen in the hydrogen-containing passivation layer is small because the size is relatively small; secondly, can further avoid that an effective contact area between the hydrogen-containing passivation layer and the corresponding doped semiconductor layer is relatively small because the size is relatively large, thereby ensuring that the hydrogen-containing passivation layer has a relatively high passivation effect on the corresponding doped semiconductor layer; and additionally, can further avoid that the first passivation sub-layer included in the second dielectric passivation layer also has a relatively large thickness and the carrier collection efficiency of the second doped semiconductor part is affected because the first passivation sub-layer included in the second dielectric passivation layer includes the hydrogen-containing passivation layer and the size of the micro-structure in the first passivation sub-layer included in the second dielectric passivation layer is relatively large.

In a possible implementation solution, a height of the at least one micro-structure is greater than or equal to 0.1 µm and less than or equal to 0.5 µm. An application principle of the beneficial effect in this case is similar to the foregoing application principle of the beneficial effect that the size of the micro-structure is greater than or equal to 10 µm and less than or equal to 20 µm, and details are not described herein again.

In a possible implementation solution, a bumpy anti-reflection structure is formed at a position corresponding to the micro-structure in the first doped semiconductor part and/or the second doped semiconductor part. In this case, reduction of the reflectance of the side of the first doped semiconductor part and/or the second doped semiconductor part facing away from the semiconductor substrate helps to refract more light into the semiconductor substrate through the first doped semiconductor part and/or the second doped semiconductor part, thereby improving the bifacial ratio of the solar cell.

In a possible implementation solution, the back contact solar cell further includes a third passivation layer disposed on the second surface, and a thickness of the third passivation layer is greater than a thickness of a part of the first passivation sub-layer included in the first dielectric passivation layer. In this case, good chemical passivation is performed on a side of the second surface of the semiconductor substrate by using the third passivation layer having a relatively large thickness, to reduce the quantity of surface defects on the side of the second surface and a carrier recombination rate.

In a possible implementation solution, the material of the first passivation sub-layer included in the first dielectric passivation layer is the same as the material of the first passivation sub-layer included in the second dielectric passivation layer. This case helps to reduce types of materials used for manufacturing different structures of the back contact solar cell, improve compatibility between the different structures, and improve the yield of the back contact solar cell.

In a possible implementation solution, the first passivation sub-layer included in the first dielectric passivation layer and the first passivation sub-layer included in the second dielectric passivation layer are integrally continuous. In this case, the first passivation sub-layer included in the first dielectric passivation layer and the first passivation sub-layer included in the second dielectric passivation layer may be simultaneously formed based on a same material and in a same step, thereby improving manufacturing efficiency of the back contact solar cell, and facilitating reduction of manufacturing costs of the back contact solar cell.

In a possible implementation solution, under a same test condition, a ratio of a PL luminance value of the side of the first passivation sub-layer included in the second dielectric passivation layer that faces away from the semiconductor substrate to a PL luminance value of the side of the first passivation sub-layer included in the first dielectric passivation layer that faces away from the semiconductor substrate is PL1. In addition, under a same test condition, a ratio of a PL luminance value of the side of the second passivation sub-layer included in the second dielectric passivation layer that faces away from the semiconductor substrate to a PL luminance value of the side of the second passivation sub-layer included in the first dielectric passivation layer that faces away from the semiconductor substrate is PL2, and PL2 is less than PL1. In this case, the second passivation sub-layer included in the first dielectric passivation layer and the second passivation sub-layer included in the second dielectric passivation layer that have different thicknesses are set, to further reduce a differentiation between the part corresponding to the first doped semiconductor part and the part corresponding to the second doped semiconductor part in terms of a passivation effect on the side of the back surface of the back contact solar cell.

In a possible implementation solution, when the second passivation sub-layer is a silicon nitride layer, PL2 is greater than or equal to 1.62 and less than or equal to 1.9. In this case, when the foregoing second passivation sub-layer is formed, the ratio between the PL luminance values of the part corresponding to the first doped semiconductor part and the part corresponding to the second doped semiconductor part on the side of the back surface of the solar cell can be further reduced, to reduce a differentiation degree in terms of passivation.

In a possible implementation solution, a difference between a refractive index of the second passivation sub-layer included in the second dielectric passivation layer and a refractive index of the second passivation sub-layer included in the first dielectric passivation layer is greater than or equal to 0.01 and less than or equal to 0.1.

In a possible implementation solution, the material of the second passivation sub-layer included in the first dielectric passivation layer is the same as the material of the second passivation sub-layer included in the second dielectric passivation layer. This case helps to reduce types of materials used for manufacturing different structures of the back contact solar cell, improve compatibility between the different structures, and improve the yield of the back contact solar cell.

In a possible implementation solution, the second passivation sub-layer included in the first dielectric passivation layer and the second passivation sub-layer included in the second dielectric passivation layer are integrally continuous. In this case, the second passivation sub-layer included in the first dielectric passivation layer and the second passivation sub-layer included in the second dielectric passivation layer may be simultaneously formed based on a same material and in a same step, thereby improving manufacturing efficiency of the back contact solar cell, and facilitating reduction of manufacturing costs of the back contact solar cell.

According to a second aspect, the present application provides a photovoltaic module. The photovoltaic module includes the back contact solar cell according to the first aspect and various implementations thereof.

For beneficial effects of the second aspect and various implementations of the second aspect in the present application, reference may be made to the analysis of the beneficial effects of the first aspect and various implementations of the first aspect, and details are not described herein.

### BRIEF DESCRIPTION OF THE DRAWINGS

The accompanying drawings described herein are intended to provide further understanding of the present application and constitute a part of the present application. Exemplary embodiments of the present application and the description thereof are used for explaining the present application rather than constituting an improper limitation to the present application. In the accompanying drawings:
FIG. 1 is a first schematic longitudinal cross-sectional view of a structure of a back contact solar cell according to an embodiment of the present application;
FIG. 2 is a second schematic longitudinal cross-sectional view of a structure of a back contact solar cell according to an embodiment of the present application;
FIG. 3 is a third schematic longitudinal cross-sectional view of a structure of a back contact solar cell according to an embodiment of the present application;
FIG. 4 is a fourth schematic longitudinal cross-sectional view of a structure of a back contact solar cell according to an embodiment of the present application;
FIG. 5 is a fifth schematic longitudinal cross-sectional view of a structure of a back contact solar cell according to an embodiment of the present application;
FIG. 6 is a first 3D diagram of a local region on a side of a back surface of a back contact solar cell according to an embodiment of the present application;
FIG. 7 is a second 3D diagram of a local region on a side of a back surface of a back contact solar cell according to an embodiment of the present application;
FIG. 8 is a first SEM diagram of a local region on a side of a back surface of a back contact solar cell according to an embodiment of the present application;
FIG. 9 is a second SEM diagram of a local region on a side of a back surface of a back contact solar cell according to an embodiment of the present application;
FIG. 10 is a 3D scanning diagram of a local region on a side of a back surface of a back contact solar cell according to an embodiment of the present application;
FIG. 11 is a SEM diagram of a local region of a side of a first doped semiconductor part facing away from a semiconductor substrate in a back contact solar cell according to an embodiment of the present application;
FIG. 12 is a sixth schematic longitudinal cross-sectional view of a structure of a back contact solar cell according to an embodiment of the present application;
FIG. 13 is a test diagram of a PL luminance value of a finished structure of a back contact solar cell on a side of a back surface according to an embodiment of the present application; and
FIG. 14 is a schematic diagram of a connection relationship between photovoltaic modules according to an embodiment of the present application.

Reference numerals: 11 is a semiconductor substrate, 12 is a first doped semiconductor part, 13 is a second doped semiconductor part, 14 is a first dielectric passivation layer, 15 is a second dielectric passivation layer, 16 is a first texture structure, 17 is a second texture structure, 18 is a micro-structure, 19 is an anti-reflection structure, 20 is a third passivation layer, 21 is a first passivation sub-layer, 22 is a second passivation sub-layer, and 23 is an interface passivation layer.

### DETAILED DESCRIPTION

The embodiments of the present application are described below with reference to the accompanying drawings. However, it should be understood that, the description is merely exemplary, and is not intended to limit a scope of the present application. In addition, in the following description, description of well-known structures and technologies is omitted, to avoid unnecessarily confusing the concept of the present application.

The accompanying drawings show various schematic structural diagrams according to the embodiments of the present application. The figures are not drawn to scale. For an objective of more clear expression, some details are enlarged, and some details may be omitted. Shapes of various regions and layers and relative sizes and position relationships between the regions and layers shown in the figures are merely exemplary. In practice, there may be a deviation due to a manufacturing tolerance or a technical limitation, and a person skilled in the art may additionally design regions/layers having different shapes, sizes and relative positions according to actual requirements.

In the context of the present application, when a layer/element is referred to as being "above" another layer/element, the layer/element may be directly above the another layer/element, or a middle layer/element may exist between them. In addition, if one layer/element is located "above" another layer/element in an orientation, when the orientation is turned, the layer/element may be located "below" the another layer/element. To make the technical problems to be resolved in the present application, the technical solutions, and beneficial effects more comprehensible, the following further describes the present application in detail with reference to the accompanying drawings and the embodiments. It should be understood that, the specific embodiments described herein are merely used to explain the present application but are not intended to limit the present application.

In addition, the terms "first" and "second" are used for descriptive purposes only and are not to be construed as indicating or implying relative importance or implicitly indicating the number of technical features indicated. Therefore, a feature defined by "first" or "second" may explicitly or implicitly include one or more features. In the description of the present application, unless otherwise explicitly specified, "a plurality of' means two or more than two; and unless clearly and specifically defined otherwise, "several" means two or more than two.

In the descriptions of the present application, it should be noted that, unless otherwise clearly specified and defined, terms such as "mounting", "interconnection", and "connection" shall be understood in a broad sense, for example, may be a fixing connection, a detachable connection, an integral connection, a mechanical connection, an electrical connection, a direct connection, an indirect connection by using an intermediate dielectric, and communication between interiors of two components or interaction between two components. The specific meanings of the foregoing terms in the present application may be understood according to specific situations for a person of ordinary skill in the art.

A solar cell is an apparatus that can convert sun's light energy into electric energy. Specifically, when the solar cell is in an operating state, sunlight irradiates onto a semiconductor p-n junction of the solar cell to form new hole-electron pairs. Under an action of a built-in electric field of the p-n junction, photogenerated holes flow to a p-type region, and photogenerated electrons flow to an n-type region, so that a current can be generated when a circuit is powered on. A solar cell with a positive electrode and a negative electrode both being located on a back surface of the solar cell is a back contact solar cell. Compared with a double-sided contact solar cell, a front surface of the back contact solar cell is not blocked by metal electrodes, so that a light receiving surface of the back contact solar cell has higher light utilization. Therefore, the back contact solar cell has a higher short-circuit current and higher photoelectric conversion efficiency, and therefore is one of existing technical directions for realizing efficient crystalline silicon solar cells. In addition, the foregoing back contact solar cell may include a surface passivation layer having both a field passivation function and a chemical passivation function, to improve a passivation effect on a side having the surface passivation layer in the back contact solar cell.

However, in the existing back contact solar cell including the foregoing surface passivation layer having both the field passivation function and the chemical passivation function, the surface passivation layer cannot satisfy both a passivation requirement of a P region and a passivation requirement of an N region, resulting in poor working performance of the solar cell. Specifically, the back contact solar cell generally includes a semiconductor substrate, a first doped semiconductor part, a second doped semiconductor part, and a surface passivation layer. The first doped semiconductor part and the second doped semiconductor part are alternately distributed on a same surface of the semiconductor substrate, and a conductivity type of the first doped semiconductor part is opposite to a conductivity type of the second doped semiconductor part. The surface passivation layer covers sides of the first doped semiconductor part and the second doped semiconductor part facing away from the semiconductor substrate. In addition, the surface passivation layer (for example, the aluminum oxide layer and/or the silicon nitride layer) has a chemical passivation function, and can perform chemical passivation on the sides of the first doped semiconductor part and the second doped semiconductor part facing away from the semiconductor substrate. In addition, a conductivity type of fixed charges of the surface passivation layer is opposite to the conductivity type of the first doped semiconductor part, so that the surface passivation layer further has a field passivation function, and can perform field passivation on the first doped semiconductor part, that is, has a strengthening effect on the electric field of the first doped semiconductor part. The electric field generated by the surface passivation layer shields the minority carriers, and accelerates collection of the majority carriers.

However, the field passivation function of the surface passivation layer has a weakening effect on the electric field of the second doped semiconductor part, and affects carrier collection of the second doped semiconductor part. In the foregoing case, for the existing back contact solar cell including the foregoing surface passivation layer, differential passivation function design is not performed according to a difference between the conductivity type of the first doped semiconductor part and the conductivity type of the second doped semiconductor part. As a result, because the thicknesses of the surface passivation layer on the first doped semiconductor part and the second doped semiconductor part are both relatively large, the carrier collection capability of the second doped semiconductor part is relatively poor, or because the thicknesses of the surface passivation layer on the first doped semiconductor part and the second doped semiconductor part are both relatively small, the surface passivation layer has a poor passivation effect on the first doped semiconductor part, which is not beneficial to improving the working efficiency of the back contact solar cell.

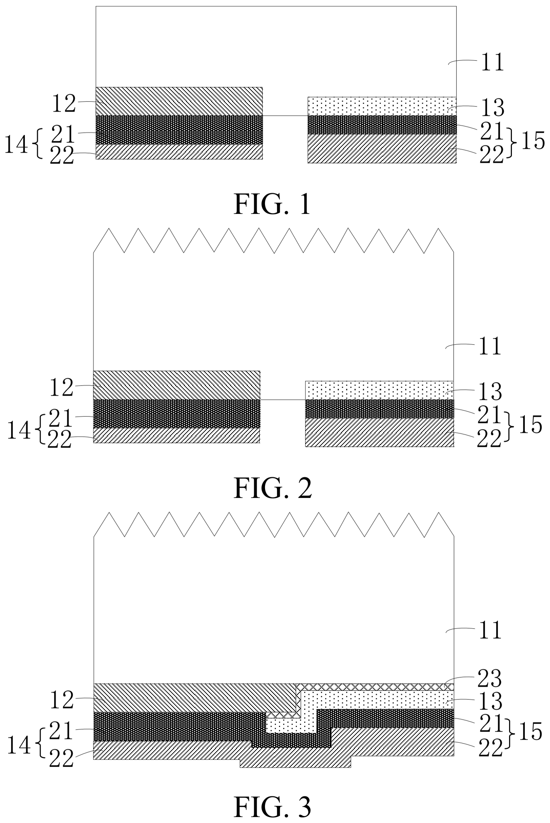

To resolve the foregoing technical problems, according to a first aspect, an embodiment of the present application provides a back contact solar cell. As shown in FIG. 1, the back contact solar cell includes: a semiconductor substrate 11, a first doped semiconductor part 12, a second doped semiconductor part 13, a first dielectric passivation layer 14, and a second dielectric passivation layer 15. A conductivity type of the first doped semiconductor part 12 is opposite to a conductivity type of the second doped semiconductor part 13. Each of the first dielectric passivation layer 14 and the second dielectric passivation layer 15 includes a first passivation sub-layer 21 having a field passivation function and a chemical passivation function. The conductivity type of the first doped semiconductor part 12 is opposite to a conductivity type of fixed charges of the first passivation sub-layer 21. The semiconductor substrate 11 includes a first surface and a second surface opposite to each other. Along a direction parallel to the first surface, the first doped semiconductor part 12 and the second doped semiconductor part 13 are alternately distributed on the first surface. The first dielectric passivation layer 14 covers a side of the first doped semiconductor part 12 facing away from the semiconductor substrate 11, and the second dielectric passivation layer 15 covers a side of the second doped semiconductor part 13 facing away from the semiconductor substrate 11. A thickness of the first passivation sub-layer 21 included in the first dielectric passivation layer 14 is greater than a thickness of the first passivation sub-layer 21 included in the second dielectric passivation layer 15. As shown in FIG. 1, each of the first dielectric passivation layer 14 and the second dielectric passivation layer may further include a second passivation sub-layer 22 having a chemical passivation function. The second passivation sub-layer 22 is disposed on a side of the first passivation sub-layer 21 facing away from the semiconductor substrate 11. A material of the second passivation sub-layer 22 included in the first dielectric passivation layer 14 is different from a material of the first passivation sub-layer 21 included in the first dielectric passivation layer 14. A material of the second passivation sub-layer 22 included in the second dielectric passivation layer 15 is different from a material of the first passivation sub-layer 21 included in the second dielectric passivation layer 15.

When the foregoing technical solution is used, the conductivity type of the first doped semiconductor part is opposite to the conductivity type of the second doped semiconductor part, and the conductivity type of the first doped semiconductor part is opposite to the conductivity type of the fixed charges of the first passivation sub-layer that is included in the first dielectric passivation layer and that covers the side of the first doped semiconductor part facing away from the semiconductor substrate and the conductivity type of the fixed charges of the first passivation sub-layer that is included in the second dielectric passivation layer and that covers the side of the second doped semiconductor part facing away from the semiconductor substrate. In addition, the first passivation sub-layer included in the first dielectric passivation layer may sense, on a side close to the first doped semiconductor part, charges having a conductivity type opposite to that of the first doped semiconductor part, and a side of the first passivation sub-layer included in the first dielectric passivation layer facing away from the first doped semiconductor part has charges having a same conductivity type as that of the first doped semiconductor part, so that an electric field is generated at the first passivation sub-layer included in the first dielectric passivation layer. Because the conductivity type of the fixed charges of the first passivation sub-layer included in the first dielectric passivation layer is opposite to the conductivity type of the dopant in the first doped semiconductor part, the electric field can shield minority carriers, to enhance a carrier collection capability and a carrier separation capability of the first doped semiconductor part. On the contrary, an electric field generated in the first passivation sub-layer included in the second dielectric passivation layer forms a reverse field at the second doped semiconductor part whose fixed charges have the same conductivity type as that of the first passivation sub-layer. In this case, the field passivation function of the first passivation sub-layer that is included in the second dielectric passivation layer has a weakening effect on the electric field of the second doped semiconductor part, and affects a carrier collection capability of the second doped semiconductor part. Secondly, within a particular range, the field passivation effect of the first passivation sub-layer included in the first dielectric passivation layer and the second dielectric passivation layer is directly proportional to the thickness of the first passivation sub-layer. Based on this, as shown in FIG. 1, when a thickness of the first passivation sub-layer 21 included in the first dielectric passivation layer 14 is greater than a thickness of the first passivation sub-layer 21 included in the second dielectric passivation layer 15, the first passivation sub-layer 21 included in the second dielectric passivation layer 15 and disposed on the side of the second doped semiconductor part 13 facing away from the semiconductor substrate 11 has a relatively small thickness. In this case, the first passivation sub-layer 21 included in the second dielectric passivation layer 15 and having a relatively small thickness can weaken the effect of the first passivation sub-layer on the reverse field of the second doped semiconductor part 13, so that the second doped semiconductor part 13 has relatively high carrier collection efficiency. In addition, due to existence of both the first passivation sub-layer 21 and the second passivation sub-layer 22 included in the second dielectric passivation layer 15, chemical passivation can be performed on the surface of the second doped semiconductor part 13, to reduce surface defects of the second doped semiconductor part 13. In addition, the first passivation sub-layer 21 included in the first dielectric passivation layer 14 and disposed on the side of the first doped semiconductor part 12 facing away from the semiconductor substrate 11 has a relatively large thickness. In this case, the first passivation sub-layer 21 included in the first dielectric passivation layer 14 and having a relatively large thickness has a higher field passivation effect of a co-directional field on the first doped semiconductor part 12, to enhance a carrier collection capability of the first doped semiconductor part 12 and reduce surface defects of the first doped semiconductor part 12. It can be seen that, in the back contact solar cell provided in this embodiment of the present application, for a case that the conductivity type of the first doped semiconductor part 12 is different from that of the second doped semiconductor part 13 and the first dielectric passivation layer 14 has a relatively high field passivation effect and a relatively high chemical passivation effect on the first doped semiconductor part 12, weakening impact of the second dielectric passivation layer 15 on the field passivation effect of the second doped semiconductor part 13 is reduced. In addition, a passivation requirement for doped semiconductor parts of two different conductivity types is satisfied, so that each of a part corresponding to the first doped semiconductor part 12 and a part corresponding to the second doped semiconductor part 13 has a relatively low carrier recombination rate and a relatively high carrier separation capability on a side of a back surface of the back contact solar cell, thereby improving the working performance of the back contact solar cell.

In an actual application process, a material and a conductivity type of the semiconductor substrate are not specifically limited in the embodiments of the present application. For example, the semiconductor substrate may be a silicon substrate. Alternatively, the semiconductor substrate may be any substrate made of a semiconductor material, for example, a germanium silicon substrate, a germanium substrate, or a gallium arsenide substrate. In addition, the semiconductor substrate may be an N-type semiconductor substrate or may be a P-type semiconductor substrate.

The semiconductor substrate includes the first surface and the second surface opposite to the first surface, the first surface of the semiconductor substrate corresponds to a back surface of the back contact solar cell, and the second surface of the semiconductor substrate corresponds to a light receiving surface of the back contact solar cell. As shown in FIG. 1 and FIG. 2, the second surface of the semiconductor substrate 11 may be a flat surface or a textured surface. That the second surface of the semiconductor substrate 11 is a textured surface helps to improve a light trapping effect of the second surface and improve light utilization of the back contact solar cell.

For the surface topography of the first surface of the semiconductor substrate, the first doped semiconductor part and the second doped semiconductor part are alternately distributed on the first surface of the semiconductor substrate. In addition, the surface topography of the sides of the first doped semiconductor part and the second doped semiconductor part facing away from the semiconductor substrate is affected by the surface topography of the corresponding region on which the foregoing two doped semiconductor layers are formed on the semiconductor substrate. The surface topography of the sides of the first doped semiconductor part and the second doped semiconductor part facing away from the semiconductor substrate affects the surface roughness of the first doped semiconductor part and the second doped semiconductor part, and further affects the thicknesses of the first passivation sub-layer included in the first dielectric passivation layer and the first passivation sub-layer included in the second dielectric passivation layer that are respectively formed on the sides of the first doped semiconductor part and the second doped semiconductor part facing away from the semiconductor substrate. Based on this, the topography of different region surfaces in the semiconductor substrate may be determined according to a thickness requirement for the first passivation sub-layer included in the first dielectric passivation layer and the first passivation sub-layer included in the second dielectric passivation layer in an actual application scenario.

For example, the first surface of the semiconductor substrate may be a polished surface or a texture structure is further formed on the polished surface. Moreover, in the first surface, a side length of the tower base-shaped texture structure formed on the region surface corresponding to the first doped semiconductor part may be greater than a side length of the tower base-shaped texture structure formed on the region surface corresponding to the second doped semiconductor part; and/or in the first surface, a height of the tower base-shaped texture structure formed on the region surface corresponding to the first doped semiconductor part may be less than a height of the tower base-shaped texture structure formed on the region surface corresponding to the second doped semiconductor part.

For another example, the first surface of the semiconductor substrate may be a textured surface. In addition, in the first surface, a side length of a base (or a length of a diagonal line) of the pyramid-shaped textured structure formed on the region surface corresponding to the first doped semiconductor part may be less than a side length of a base (or a length of a diagonal line) of the pyramid-shaped textured structure formed on the region surface corresponding to the second doped semiconductor part; and/or in the first surface, a height of the pyramid-shaped textured structure formed on the region surface corresponding to the first doped semiconductor part may be less than a height of the pyramid-shaped textured structure formed on the region surface corresponding to the second doped semiconductor part.

For still another example, in the first surface, a region surface corresponding to the first doped semiconductor part may be a polished face, or a texture structure is further formed on the polished face, and a region surface corresponding to the second doped semiconductor part may be a textured structure.

It should be noted that surface topographies of regions on the first surface of the semiconductor substrate may alternatively be the same. In this case, the first passivation sub-layer included in the first dielectric passivation layer and the first passivation sub-layer included in the second dielectric passivation layer that have different thicknesses may be obtained in a manner such as adjusting formation parameters for manufacturing the first passivation sub-layer included in the first dielectric passivation layer and the first passivation sub-layer included in the second dielectric passivation layer.

For the first doped semiconductor part and the second doped semiconductor part, in terms of conductivity types, the conductivity type of the first doped semiconductor part and the conductivity type of the second doped semiconductor part are not specifically limited in the embodiments of the present application, provided that the conductivity type of the first doped semiconductor part is opposite to the conductivity type of the second doped semiconductor part, and the conductivity type of the first doped semiconductor part is opposite to the conductivity type of the fixed charges of the first passivation sub-layer. Specifically, the conductivity type of the first doped semiconductor part may be an N type. In this case, the conductivity type of the second doped semiconductor part is a P type, and both the first passivation sub-layer included in the first dielectric passivation layer and the first passivation sub-layer included in the second dielectric passivation layer have fixed negative charges. Alternatively, the conductivity type of the first doped semiconductor part may be a P type. In this case, the conductivity type of the second doped semiconductor part is an N type, and both the first passivation sub-layer included in the first dielectric passivation layer and the first passivation sub-layer included in the second dielectric passivation layer have fixed positive charges.

In terms of distribution, as shown in FIG. 1, the first doped semiconductor part 12 may be disposed in a local region on the first surface of the semiconductor substrate 11. Alternatively, as shown in FIG. 3, the first doped semiconductor part 12 may be disposed on a local region on the first surface of the semiconductor substrate 11.

As for the second doped semiconductor part, as shown in FIG. 2, the second doped semiconductor part 13 may be disposed in a local region on the first surface of the semiconductor substrate 11. Alternatively, as shown in FIG. 3, the second doped semiconductor part 13 may be at least disposed on a local region on the first surface of the semiconductor substrate 11.

When the first doped semiconductor part and the second doped semiconductor part are both doped semiconductor layers disposed on the first surface, as shown in FIG. 1 and FIG. 2, the first doped semiconductor part 12 and the second doped semiconductor part 13 may be alternately distributed on a side of the first surface of the semiconductor substrate 11 at an interval. Alternatively, as shown in FIG. 3, the second doped semiconductor part 13 may cover a partial region of the first doped semiconductor part 12, and the second doped semiconductor part 13 and the first doped semiconductor part 12 are disposed at an interval along at least a thickness direction of the semiconductor substrate 11, to prevent short circuiting.

In terms of materials, when at least one of the first doped semiconductor part and the second doped semiconductor part is a doped semiconductor layer disposed on the first surface, a material of the doped semiconductor layer may include any one of semiconductor materials such as silicon, germanium-silicon, germanium, or gallium arsenide. In terms of an arrangement form of a material, the crystalline phase of the doped semiconductor layer may be amorphous, microcrystalline, nanocrystalline, monocrystalline, polycrystalline, or the like. When the first doped semiconductor part and the second doped semiconductor part are both doped semiconductor layers disposed on the first surface, the materials of the first doped semiconductor part and the second doped semiconductor part may be the same, or may be different. For example, the material of each of the first doped semiconductor part and the second doped semiconductor part may be a doped polysilicon. For another example, the material of each of the first doped semiconductor part and the second doped semiconductor part may include at least one of doped amorphous silicon, doped microcrystalline silicon, and doped nanocrystalline silicon. For another example, the material of the first doped semiconductor part may be doped polycrystalline silicon, and the material of the second doped semiconductor part may include at least one of doped amorphous silicon, doped microcrystalline silicon, and doped nanocrystalline silicon.

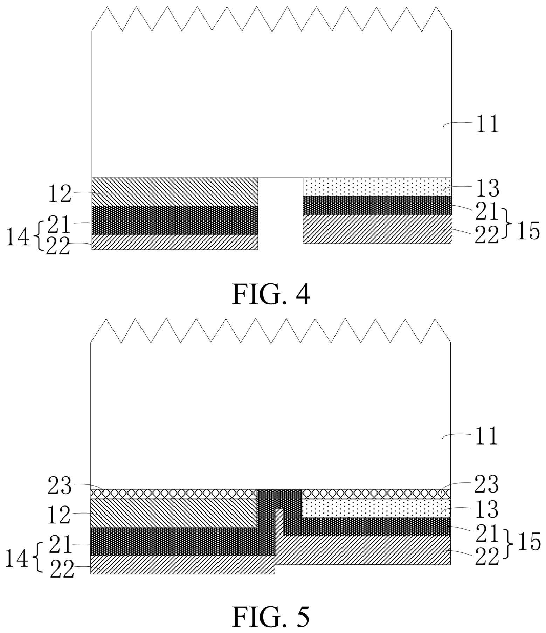

Secondly, as shown in FIG. 1 and FIG. 2, when at least one of the first doped semiconductor part 12 and the second doped semiconductor part 13 is a doped semiconductor layer disposed on the first surface, the doped semiconductor layer may be directly disposed on the semiconductor substrate 11. Alternatively, as shown in FIG. 3 and FIG. 5, the back contact solar cell may include an interface passivation layer 23, and the interface passivation layer 23 is disposed at least between the doped semiconductor layer and the semiconductor substrate 11. In this case, a passivation contact structure formed by the interface passivation layer 23 and the doped semiconductor layer has an excellent interface passivation effect, and can implement selective collection of carriers, reduce a carrier recombination rate on a corresponding region surface in the first surface of the semiconductor substrate 11, and further improve the photoelectric conversion efficiency of the back contact solar cell. A material and a thickness of the interface passivation layer 23 may be set according to a material of the doped semiconductor layer and an actual requirement, and are not specifically limited herein. For example, when the material of the doped semiconductor layer is doped polycrystalline silicon, the interface passivation layer is a tunneling passivation layer. For another example, when a material of the doped semiconductor layer includes at least one of doped amorphous silicon, doped microcrystalline silicon, and doped nanocrystalline silicon, the interface passivation layer is an intrinsic amorphous silicon layer, an intrinsic microcrystalline silicon layer, an intrinsic nanocrystalline silicon layer, or a hybrid layer of the foregoing three layers.

When the first doped semiconductor part and the second doped semiconductor part are both doped semiconductor layers disposed on the first surface, the interface passivation layer may be disposed between only the first doped semiconductor part and the semiconductor substrate. Alternatively, as shown in FIG. 3, the interface passivation layer 23 may be disposed between only the second doped semiconductor part 13 and the semiconductor substrate 11. Alternatively, as shown in FIG. 5, an interface passivation layer 23 may be disposed between the first doped semiconductor part 12 and the semiconductor substrate 11, and between the second doped semiconductor part 13 and the semiconductor substrate 11. In this case, a type of a first selective contact structure including the first doped semiconductor part 12 and the interface passivation layer 23 may be the same as or different from a type of a second selective contact structure including the second doped semiconductor part 13 and the interface passivation layer 23.

In an embodiment, the first selective contact structure and the second selective contact structure may be both tunneling passivation contact structures.

In terms of surface topography, the surface topography of the side of the first doped semiconductor part facing away from the semiconductor substrate and the surface topography of the side of the second doped semiconductor part facing away from the semiconductor substrate affect the surface reflectance of the side of the first doped semiconductor part facing away from the semiconductor substrate and the surface reflectance of the side of the second doped semiconductor part facing away from the semiconductor substrate. The surface reflectance is inversely proportional to a specific surface area. A larger specific surface area indicates a higher surface light trapping effect and a lower surface reflectance. Secondly, the specific surface area is in direct proportion to a surface roughness, and a larger specific surface area indicates a higher surface roughness. In addition, under a same condition, the thickness of a deposited film of the first passivation sub-layer included in the first dielectric passivation layer and the thickness of a deposited film of the first passivation sub-layer included in the second dielectric passivation layer are inversely proportional to the roughness of the surface on which the first passivation sub-layer included in the first dielectric passivation layer and the first passivation sub-layer included in the second dielectric passivation layer are deposited. Based on this, the surface topography and the surface reflectance of the side of the first doped semiconductor part facing away from the semiconductor substrate and the surface topography and the surface reflectance of the side of the second doped semiconductor part facing away from the semiconductor substrate may be determined according to a thickness requirement for the first passivation sub-layer included in the first dielectric passivation layer and the first passivation sub-layer included in the second dielectric passivation layer in an actual application scenario and an actual manufacturing process of the back contact solar cell.

Specifically, a surface reflectance of the side of the first doped semiconductor part facing away from the semiconductor substrate may be equal to a surface reflectance of the side of the second doped semiconductor part facing away from the semiconductor substrate. In this case, different film thicknesses may be obtained by adjusting condition parameters for manufacturing the first passivation sub-layer included in the first dielectric passivation layer and the first passivation sub-layer included in the second dielectric passivation layer.

Alternatively, a surface reflectance of the side of the first doped semiconductor part facing away from the semiconductor substrate may be greater than a surface reflectance of the side of the second doped semiconductor part facing away from the semiconductor substrate. In this case, the surface roughness of the side of the first doped semiconductor part facing away from the semiconductor substrate is relatively small, and the surface roughness of the side of the second doped semiconductor part facing away from the semiconductor substrate is relatively large. As described above, under the same condition, the deposition thicknesses of film layers of the first passivation sub-layer included in the first dielectric passivation layer and the first passivation sub-layer included in the second dielectric passivation layer are inversely proportional to the roughness of the surface on which the first passivation sub-layers are deposited. Therefore, this case that the surface roughness of the side of the first doped semiconductor part facing away from the semiconductor substrate is relatively small helps, when the first passivation sub-layer included in the first dielectric passivation layer and the first passivation sub-layer included in the second dielectric passivation layer are manufactured under a same process condition, to form, on the side of the first doped semiconductor part facing away from the semiconductor substrate, the first passivation sub-layer included in the first dielectric passivation layer and having a relatively large thickness, thereby improving a field passivation effect of the first passivation sub-layer included in the first dielectric passivation layer, and to form, on the side of the second doped semiconductor part facing away from the semiconductor substrate, the first passivation sub-layer included in the second dielectric passivation layer and having a relatively small thickness, thereby reducing a field passivation effect of the first passivation sub-layer included in the second dielectric passivation layer, reducing a differentiation degree between the part corresponding to the first doped semiconductor part and the part corresponding to the second doped semiconductor part on the side of the back surface of the solar cell in terms of comprehensive passivation effect. In addition, this case that the surface roughness of the side of the second doped semiconductor part facing away from the semiconductor substrate is relatively large helps to form, on the side of the second doped semiconductor part facing away from the semiconductor substrate, the first passivation sub-layer included in the second dielectric passivation layer and having a relatively small thickness, thereby reducing impact of the field passivation effect of the first passivation sub-layer included in the second dielectric passivation layer on carrier collection efficiency of the second doped semiconductor part. The difference between the surface reflectance of the side of the first doped semiconductor part facing away from the semiconductor substrate and the surface reflectance of the side of the second doped semiconductor part facing away from the semiconductor substrate may be determined according to the difference between the thicknesses of the first passivation sub-layer included in the first dielectric passivation layer and the first passivation sub-layer included in the second dielectric passivation layer, and is not specifically limited herein.

Secondly, the surface topography of the side of the first doped semiconductor part facing away from the semiconductor substrate may be the same as the surface topography of the side of the second doped semiconductor part facing away from the semiconductor substrate. In this case, different film thicknesses may be obtained by adjusting condition parameters for manufacturing the first passivation sub-layer included in the first dielectric passivation layer and the first passivation sub-layer included in the second dielectric passivation layer.

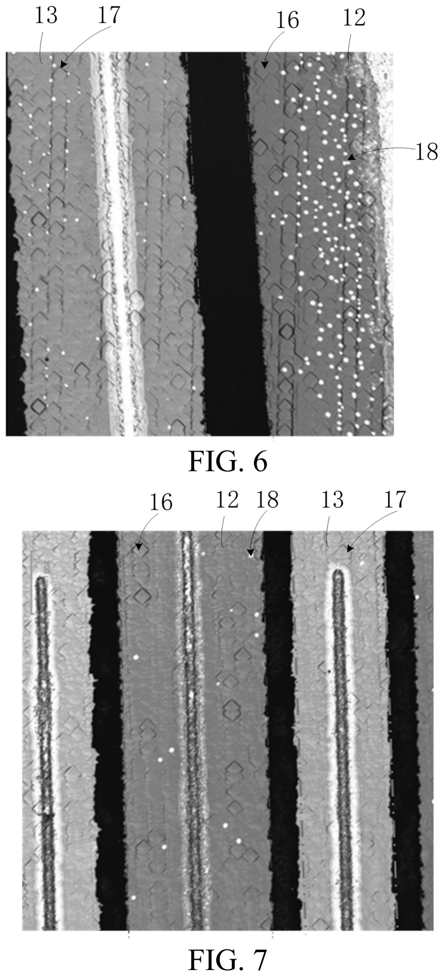

Alternatively, the surface topography of the side of the first doped semiconductor part facing away from the semiconductor substrate may be different from the surface topography of the side of the second doped semiconductor part facing away from the semiconductor substrate. Based on this, as shown in FIG. 6 and FIG. 7, a side of the first doped semiconductor part 12 facing away from the semiconductor substrate may have a first texture structure 16, and a side of the second doped semiconductor part 13 facing away from the semiconductor substrate may have a second texture structure 17. A one-dimensional size of the first texture structure 16 is different from a one-dimensional size of the second texture structure 17, and/or types of the first texture structure 16 and the second texture structure 16 are different. Types of the first texture structure 16 and the second texture structure 17 may be set according to an actual requirement. For example, the first texture structure and the second texture structure may be tower base-shaped texture structures. A bottom surface of the tower base-shaped texture structure may be a bottom surface that is regularly or irregularly polygonal and has an arc-shaped contour, or the like. A specific meaning of the one-dimensional size may be determined according to types of the first texture structure and the second texture structure. For example, when the first texture structure and/or the second texture structure is a tower base-shaped texture structure, the one-dimensional size may be a height, a side length, a diagonal length, a circumference, or the like of the tower base-shaped texture structure.

Three examples of the surface topography of the side of the first doped semiconductor part facing away from the semiconductor substrate and the side of the second doped semiconductor part facing away from the semiconductor substrate are given below, but the three examples are merely used to explain the present application, and are not used to limit the present application.

For example, as shown in FIG. 6 and FIG. 7, a side of the first doped semiconductor part 12 facing away from the semiconductor substrate may have a first tower base-shaped texture structure, and a side of the second doped semiconductor part 13 facing away from the semiconductor substrate may have a second tower base-shaped texture structure. A side length of the first tower base-shaped texture structure may be greater than a side length of the second tower base-shaped texture structure, and/or a height of the first tower base-shaped texture structure may be less than a height of the second tower base-shaped texture. In this case, when the side length of the first tower base-shaped texture structure is greater than the side length of the second tower base-shaped texture structure, and the height of the first tower base-shaped texture structure is less than the height of the second tower base-shaped texture structure, the side surface, on which the first tower base-shaped texture structure is formed, of the first doped semiconductor part 12 facing away from the semiconductor substrate 11 has a larger reflectance and a lower surface roughness, which helps to form, on the side of the first doped semiconductor part 12 facing away from the semiconductor substrate, the first passivation sub-layer 21 included in the first dielectric passivation layer and having a relatively large thickness, thereby improving a field passivation effect of the first passivation sub-layer 21 included in the first dielectric passivation layer, and to form, on the side of the second doped semiconductor part 13 facing away from the semiconductor substrate, the first passivation sub-layer 21 included in the second dielectric passivation layer 15 and having a relatively small thickness, thereby reducing a field passivation effect of the first passivation sub-layer 21 included in the second dielectric passivation layer 15, reducing a differentiation degree between the part corresponding to the first doped semiconductor part 12 and the part corresponding to the second doped semiconductor part 13 on the side of the back surface of the solar cell in terms of comprehensive passivation effect. In addition, the side surface, on which the second tower base-shaped texture structure having a smaller side length and/or a larger height is formed, of the second doped semiconductor part 13 facing away from the semiconductor substrate has a smaller reflectance and a higher surface roughness, which helps to form, on the side of the second doped semiconductor part 13 facing away from the semiconductor substrate, the first passivation sub-layer 21 included in the second dielectric passivation layer 15 and having a relatively small thickness, thereby reducing impact of the field passivation effect of the first passivation sub-layer 21 included in the second dielectric passivation layer 15 on carrier collection efficiency of the second doped semiconductor part 13. The side length and the height of the first tower base-shaped texture structure, and the side length and the height of the second tower base-shaped texture may be determined according to the difference between the thicknesses of the first passivation sub-layer 21 included in the first dielectric passivation layer and the first passivation sub-layer 21 included in the second dielectric passivation layer 15, and are not specifically limited herein.

For example, a side of the first doped semiconductor part facing away from the semiconductor substrate may have a tower base-shaped texture structure, and a side of the second doped semiconductor part facing away from the semiconductor substrate may have a pyramid-shaped textured structure.

For example, a side of the first doped semiconductor part facing away from the semiconductor substrate may have a first pyramid-shaped textured structure, and a side of the second doped semiconductor part facing away from the semiconductor substrate may have a second pyramid-shaped textured structure. A side length of the first pyramid-shaped textured structure may be less than a side length of the second pyramid-shaped textured structure, and/or, a height of the first pyramid-shaped textured structure may be less than a height of the second tower base-shaped texture structure.

The doping concentrations of the dopant in and the thicknesses of the first doped semiconductor part and the second doped semiconductor part may be set according to an actual requirement. As described above, the first passivation sub-layer included in the first dielectric passivation layer may form a superimposed field at the first doped semiconductor part, thereby improving carrier collection efficiency of the first doped semiconductor part. The first passivation sub-layer included in the second dielectric passivation layer forms a reverse field at the second doped semiconductor part, affecting carrier collection efficiency of the second doped semiconductor part. In addition, the doping concentrations of the dopant in and the thicknesses of the first doped semiconductor part and the second doped semiconductor part affect the field passivation effects of the first doped semiconductor part and the second doped semiconductor part. Therefore, the doping concentrations of the dopant in and the thicknesses of the first doped semiconductor part and the second doped semiconductor part may be determined according to a requirement on field passivation effects of the first doped semiconductor part and the second doped semiconductor part in an actual application scenario.

For example, a doping concentration of a dopant in the first doped semiconductor part may be less than or equal to a doping concentration of a dopant in the second doped semiconductor part. When the doping concentration of the dopant in the second doped semiconductor part is relatively large, the electric field generated by the second doped semiconductor part has a larger strength, so that a difference between the carrier collection capabilities of the second doped semiconductor part and the first doped semiconductor part caused by a suppression effect of the reverse field formed by the field passivation function of the first passivation sub-layer included in the second dielectric passivation layer can be compensated for, thereby facilitating uniform collection of carriers of different conductivity types.

For example, the doping concentration of the dopant in the first doped semiconductor part may range from 6E19 cm⁻³ to 7E19 cm⁻³; and/or the doping concentration of the dopant in the second doped semiconductor part may range from 5E20 cm⁻³ to 6E20 cm⁻³.

For example, as shown in FIG. 4, a thickness of the first doped semiconductor part 12 may be greater than or equal to a thickness of the second doped semiconductor part 13. That the thickness of the first doped semiconductor part 12 is greater than a thickness of the second doped semiconductor part 13 helps to increase a field passivation effect of the first doped semiconductor part 12 on the corresponding regional surface of the semiconductor substrate 11, which can further reduce the ratio between the PL luminance values of the part corresponding to the first doped semiconductor part 12 and the part corresponding to the second doped semiconductor part 13 on the side of the back surface of the solar cell, to reduce a differentiation degree in terms of passivation.

For example, the thickness of the first doped semiconductor part may range from 200 nm to 400 nm; and/or the thickness of the second doped semiconductor part may range from 100 nm to 300 nm.

For the foregoing first dielectric passivation layer and second dielectric passivation layer, in terms of materials, a material of the first passivation sub-layer included in the first dielectric passivation layer and a material of the first passivation sub-layer included in the second dielectric passivation layer may be determined according to conductivity types of fixed charges in the first passivation sub-layer included in the first dielectric passivation layer and the first passivation sub-layer included in the second dielectric passivation layer, as long as a conductivity type of the first doped semiconductor part is opposite to each of the conductivity type of fixed charges of the first passivation sub-layer included in the first dielectric passivation layer and the conductivity type of fixed charges of the first passivation sub-layer included in the second dielectric passivation layer, and the first passivation sub-layer has at least a field passivation function. The material of the first passivation sub-layer included in the first dielectric passivation layer and the material of the first passivation sub-layer included in the second dielectric passivation layer may include a single-layer material or may include a laminated material, provided that at least one layer has the same type of fixed charges, to ensure that the type of fixed charges of the first passivation sub-layer included in the first dielectric passivation layer and the type of fixed charges of the first passivation sub-layer included in the second dielectric passivation layer are the same.

For example, a material of the first passivation sub-layer or the second passivation sub-layer may include at least one of materials such as aluminum oxide, silicon nitride, silicon oxide, and silicon oxynitride.

For example, the first passivation sub-layer included in the first dielectric passivation layer or the second dielectric passivation layer may include: a negatively charged dielectric passivation layer such as aluminum oxide, and the second passivation sub-layer includes a laminated combination of one or more of materials such as silicon nitride, silicon oxide, and silicon oxynitride, as long as the first dielectric passivation layer and the second dielectric passivation layer have both a chemical passivation function and a field passivation function. Specifically, the first passivation sub-layer included in the first dielectric passivation layer and/or the first passivation sub-layer included in the second passivation layer may alternatively be a laminated structure including a plurality of passivation layers, and a particular passivation layer in the laminated structure may have both a chemical passivation function and a field passivation function, or some passivation layers in the laminated structure have only a chemical passivation function or only a field passivation function. Descriptions are provided by using the first passivation sub-layer included in the first dielectric passivation layer as an example: When the first doped semiconductor part is a P-type doped semiconductor part, the first passivation sub-layer included in the first dielectric passivation layer may include an aluminum oxide layer, and the second passivation sub-layer includes silicon nitride disposed on a side of the aluminum oxide layer facing away from the semiconductor substrate. For another example, when the first doped semiconductor part is a P-type doped semiconductor part, the first passivation sub-layer included in the first dielectric passivation layer may include an aluminum oxide layer, and the second passivation sub-layer includes silicon oxynitride disposed on a side of the aluminum oxide layer facing away from the semiconductor substrate. For still another example, when the first doped semiconductor part is a P-type doped semiconductor part, the first passivation sub-layer included in the first dielectric passivation layer may include an aluminum oxide layer, and the second passivation sub-layer may include a silicon nitride layer, a silicon oxynitride layer, and a silicon oxide layer that are sequentially stacked along the thickness direction of the solar cell. For another example, when the first doped semiconductor part is a P-type doped semiconductor part, the first passivation sub-layer included in the first dielectric passivation layer may include a silicon oxide layer and an aluminum oxide layer that are sequentially stacked along the thickness direction of the solar cell, and the second passivation sub-layer may include a silicon nitride layer that is sequentially stacked along the thickness direction of the solar cell.

In addition, the material of the first passivation sub-layer included in the first dielectric passivation layer and the material of the first passivation sub-layer included in the second dielectric passivation layer may be the same or different, and may be differently selected according to different conductivity types of the first doped semiconductor part. Specifically, when the material of the first passivation sub-layer included in the first dielectric passivation layer is the same as the material of the first passivation sub-layer included in the second dielectric passivation layer, the materials of the two first passivation sub-layers may both include a material having negative fixed charges, such as aluminum oxide, or may both include at least one of materials having positive fixed charges, such as silicon oxide, silicon nitride, and silicon oxynitride. Secondly, when the material of the first passivation sub-layer included in the first dielectric passivation layer is different from the material of the first passivation sub-layer included in the second dielectric passivation layer, if the conductivity type of the first doped semiconductor part is P-type, the two first passivation sub-layers may be materials being of different material types and both having negative fixed charges. In this case, a material of the second passivation sub-layer may be selected from at least one of materials having positive fixed charges, such as silicon oxide, silicon nitride, and silicon oxynitride. The second passivation sub-layer can make up for the weakening effect of the material with negative fixed charges on the field passivation effect of the second doped semiconductor part, and can also provide a better chemical passivation effect on the first doped semiconductor part and the second doped semiconductor part. If the conductivity type of the first doped semiconductor part is N-type, the two first passivation sub-layers may be materials being of different material types and both having positive fixed charges, which can also provide a better chemical passivation effect on the first doped semiconductor part and the second doped semiconductor part in addition to performing a field passivation effect. In this case, a material of the second passivation sub-layer may be selected from a material having negative fixed charges, such as aluminum oxide. In this case, the second passivation sub-layer can make up for the weakening effect of the material with positive fixed charges on the field passivation effect of the second doped semiconductor part.

The case that the material of the first passivation sub-layer included in the first dielectric passivation layer is the same as the material of the first passivation sub-layer included in the second dielectric passivation layer helps to reduce types of materials used for manufacturing different structures of the back contact solar cell, improve compatibility between the different structures, and improve the yield of the back contact solar cell.

Secondly, as shown in FIG. 5, the first passivation sub-layer 21 included in the first dielectric passivation layer 14 and the first passivation sub-layer 21 included in the second dielectric passivation layer 15 may alternatively be integrally continuous. In this case, the first passivation sub-layer 21 included in the first dielectric passivation layer 14 and the first passivation sub-layer 21 included in the second dielectric passivation layer 15 may be simultaneously formed based on a same material and in a same step, thereby improving manufacturing efficiency of the back contact solar cell, and facilitating reduction of manufacturing costs of the back contact solar cell. Certainly, the first passivation sub-layer 21 included in the first dielectric passivation layer 14 and the first passivation sub-layer 21 included in the second dielectric passivation layer 15 may alternatively be separately manufactured in different operation steps, as long as the conductivity type of the first doped semiconductor part 12 is opposite to each of the conductivity type of the fixed charges of the first passivation sub-layer 21 included in the first dielectric passivation layer 14 and the conductivity type of the fixed charges of the first passivation sub-layer 21 included in the second dielectric passivation layer 15, and the thickness of the first passivation sub-layer 21 included in the first dielectric passivation layer 14 is greater than the thickness of the first passivation sub-layer 21 included in the second dielectric passivation layer 15.

For example, the first passivation sub-layer included in the first dielectric passivation layer and/or the first passivation sub-layer included in the second dielectric passivation layer includes a hydrogen-containing passivation layer, to implement chemical passivation on the corresponding doped semiconductor part in a manner of hydrogen passivation, and reduce the quantity of defects on the side of the corresponding doped semiconductor part facing away from the semiconductor substrate. For example, the first passivation sub-layer included in the first dielectric passivation layer and/or the first passivation sub-layer included in the second dielectric passivation layer may include at least one of film layers such as an aluminum oxide layer, a silicon oxide layer, a silicon nitride layer, and a silicon oxynitride layer.

Specifically, in the first dielectric passivation layer and the second dielectric passivation layer, only the first passivation sub-layer included in the first dielectric passivation layer may be a hydrogen-containing passivation layer, or only the first passivation sub-layer included in the second dielectric passivation layer may be a hydrogen-containing passivation layer, or each of the first passivation sub-layer included in the first dielectric passivation layer and the first passivation sub-layer included in the second dielectric passivation layer may be a hydrogen-containing passivation layer.

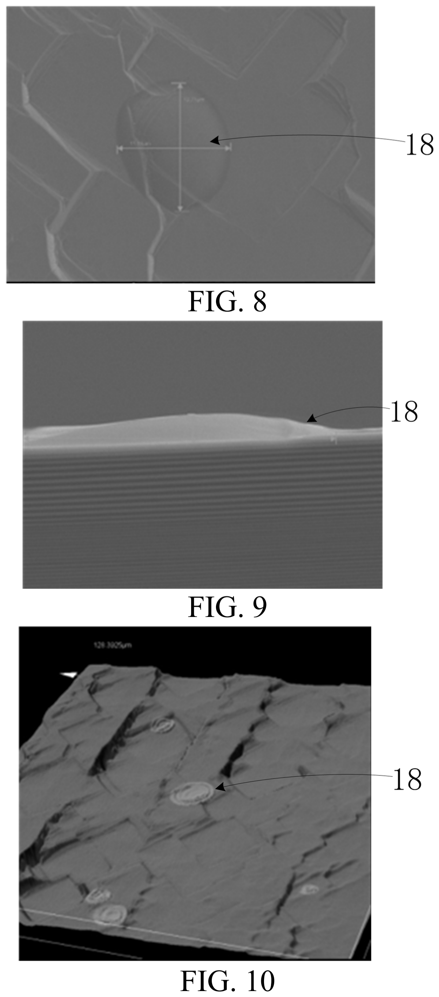

For example, and a local region of the hydrogen-containing passivation layer may have a micro-structure. As shown in FIG. 8 and FIG. 9, at least one micro-structure 18 may be a structure that is bulged in a direction away from the semiconductor substrate 11; and/or as shown in FIG. 10, at least one micro-structure 18 may be a micro-structure 18 that is sunken or bulged in the middle and that has a cyclonic shape at an edge. In this case, when the at least one micro-structure 18 is a structure that is bulged in a direction away from the semiconductor substrate 11, an accommodating space that is formed by bulging exists between the hydrogen-containing passivation layer having the micro-structure 18 and the corresponding doped semiconductor part, and the accommodating space has hydrogen gas that generates the bulged structure. This case indicates that the content of hydrogen ions in the hydrogen-containing passivation layer is sufficient, so that the hydrogen-containing passivation layer has a higher hydrogen passivation effect on a corresponding doped semiconductor layer, thereby further reducing surface defects of the corresponding doped semiconductor layer. Secondly, the hydrogen gas in the bulged structure can further continuously provide hydrogen ions in a subsequent manufacturing process or solar cell working process, so as to achieve continuous hydrogen passivation on the corresponding doped semiconductor layer, thereby helping to improve the yield of the solar cell and prolong the service life of the solar cell. In addition, when the at least one micro-structure 18 is a micro-structure 18 that is sunken or bulged in the middle and that has a cyclonic shape at an edge, it indicates that the content of hydrogen in the hydrogen-containing passivation layer is higher, so that a sufficient amount of hydrogen ions is used without hydrogen passivation, and film explosion occurs in the micro-structure 18 after hydrogen ions escape from the hydrogen-containing passivation layer. Based on this, when the hydrogen-containing passivation layer includes such a micro-structure 18, the hydrogen-containing passivation layer has a higher hydrogen passivation effect on the corresponding doped semiconductor layer. In addition, after film explosion occurs, a bumpy micro-structure 18 can be formed on a side of the hydrogen-containing passivation layer facing away from the semiconductor substrate 11, which helps to reduce the reflectance of the side of the hydrogen-containing passivation layer facing away from the semiconductor substrate 11, and improve a light trapping effect of the hydrogen-containing passivation layer.

Specifically, in the first dielectric passivation layer and the second dielectric passivation layer, when only the first passivation sub-layer included in the first dielectric passivation layer includes a hydrogen-containing passivation layer, the local region of the first passivation sub-layer included in the first dielectric passivation layer may have the foregoing micro-structure, or may not have the foregoing micro-structure. In the first dielectric passivation layer and the second dielectric passivation layer, when only the first passivation sub-layer included in the second dielectric passivation layer includes a hydrogen-containing passivation layer, the local region of the first passivation sub-layer included in the second dielectric passivation layer may have the foregoing micro-structure, or may not have the foregoing micro-structure. When each of the first passivation sub-layer included in the first dielectric passivation layer and the first passivation sub-layer included in the second dielectric passivation layer includes a hydrogen-containing passivation layer, only the first passivation sub-layer included in the first dielectric passivation layer may have the foregoing micro-structure, or only the first passivation sub-layer included in the second dielectric passivation layer may have the foregoing micro-structure, or each of the first passivation sub-layer included in the first dielectric passivation layer and the first passivation sub-layer included in the second dielectric passivation layer may have the foregoing micro-structure, or neither of the first passivation sub-layer included in the first dielectric passivation layer and the first passivation sub-layer included in the second dielectric passivation layer may have the foregoing micro-structure.

For example, when each of the first passivation sub-layer included in the first dielectric passivation layer and the first passivation sub-layer included in the second dielectric passivation layer includes a hydrogen-containing passivation layer, to meet a passivation requirement for two doped regions, the thickness of the first passivation sub-layer included in the first dielectric passivation layer is greater than the thickness of the first passivation sub-layer included in the second dielectric passivation layer. In this case, the local region of the first passivation sub-layer included in the first dielectric passivation layer has the foregoing micro-structure, and the first passivation sub-layer included in the second dielectric passivation layer may have the foregoing micro-structure, or may not have the foregoing micro-structure.

It may be understood that, a larger thickness and/or higher compactness of the hydrogen-containing passivation layer indicates a higher content of hydrogen in the hydrogen-containing passivation layer, and is more likely to form the foregoing micro-structure due to escape of hydrogen after the hydrogen-containing passivation layer is exposed to heat. Therefore, distribution densities of micro-structures in the first passivation sub-layer included in the first dielectric passivation layer and the first passivation sub-layer included in the second dielectric passivation layer may be determined according to whether the first passivation sub-layer included in the first dielectric passivation layer and the first passivation sub-layer included in the second dielectric passivation layer include a hydrogen-containing passivation layer, and the thicknesses and compactness of the first passivation sub-layer included in the first dielectric passivation layer and the first passivation sub-layer included in the second dielectric passivation layer. This is not specifically limited herein.

For example, as shown in FIG. 6 and FIG. 7, in the first dielectric passivation layer 14 and the second dielectric passivation layer 15, when at least the local region of the first passivation sub-layer 21 included in the first dielectric passivation layer 14 has the micro-structure 18, a distribution density of the micro-structure 18 in the first passivation sub-layer 21 included in the first dielectric passivation layer 14 is greater than a distribution density of the micro-structure 18 in the first passivation sub-layer 21 included in the second dielectric passivation layer 15. This case can help to enable the first passivation sub-layer 21 included in the first dielectric passivation layer 14 to have a larger thickness and/or higher film layer compactness (compared with the first passivation sub-layer 21 included in the second dielectric passivation layer 15), to ensure that the first passivation sub-layer 21 included in the first dielectric passivation layer 14 has a higher field passivation effect on a first doped semiconductor layer; and helps to enable the first passivation sub-layer 21 included in the second dielectric passivation layer 15 to have a relatively small thickness and/or a relatively low film layer compactness, so as to reduce impact of the field passivation function of the first passivation sub-layer 21 included in the second dielectric passivation layer 15 on carrier collection efficiency of a second doped semiconductor layer, thereby ensuring relatively high operation efficiency of the back contact solar cell.

For the size and the height of the micro-structure, when the hydrogen-containing passivation layer has the foregoing micro-structure, it indicates that the hydrogen-containing passivation layer has a sufficient content of hydrogen ions, so that the hydrogen-containing passivation layer has a relatively high chemical passivation effect on a corresponding doped semiconductor layer. In addition, due to existence of the foregoing micro-structure, at least some regions of the hydrogen-containing passivation layer at the micro-structure cannot be in contact with the corresponding doped semiconductor layer, that is, the at least some regions of the hydrogen-containing passivation layer at the micro-structure cannot perform passivation treatment on the corresponding doped semiconductor layer. Therefore, the size and the height of the micro-structure may be determined according to a requirement for a passivation effect of the hydrogen-containing passivation layer in an actual application scenario, and the thickness and compactness of the hydrogen-containing passivation layer. This is not specifically limited herein.

For example, a size of the at least one micro-structure may be greater than or equal to 10 µm and less than or equal to 20 µm. For example, the size of the micro-structure may be 10 µm, 11 µm, 12 µm, 14 µm, 16 µm, 18 µm, 20 µm, or the like. In this case, as described above, based on this, that the size of the micro-structure falls within the foregoing range can avoid that the content of hydrogen in the hydrogen-containing passivation layer is small because the size is relatively small; secondly, can further avoid that an effective contact area between the hydrogen-containing passivation layer and the corresponding doped semiconductor layer is relatively small because the size is relatively large, thereby ensuring that the hydrogen-containing passivation layer has a relatively high passivation effect on the corresponding doped semiconductor layer; and additionally, can further avoid that the first passivation sub-layer included in the second dielectric passivation layer also has a relatively large thickness and the carrier collection efficiency of the second doped semiconductor part is affected because the first passivation sub-layer included in the second dielectric passivation layer includes the hydrogen-containing passivation layer and the size of the micro-structure in the first passivation sub-layer included in the second dielectric passivation layer is relatively large.

For example, a height of the at least one micro-structure may be greater than or equal to 0.1 µm and less than or equal to 0.5 µm. For example, the height of the at least one micro-structure may be 0.1 µm, 0.15 µm, 0.2 µm, 0.25 µm, 0.3 µm, 0.4 µm, 0.5 µm, or the like. An application principle of the beneficial effect in this case is similar to the foregoing application principle of the beneficial effect that the size of the micro-structure is greater than or equal to 10 µm and less than or equal to 20 µm, and details are not described herein again.

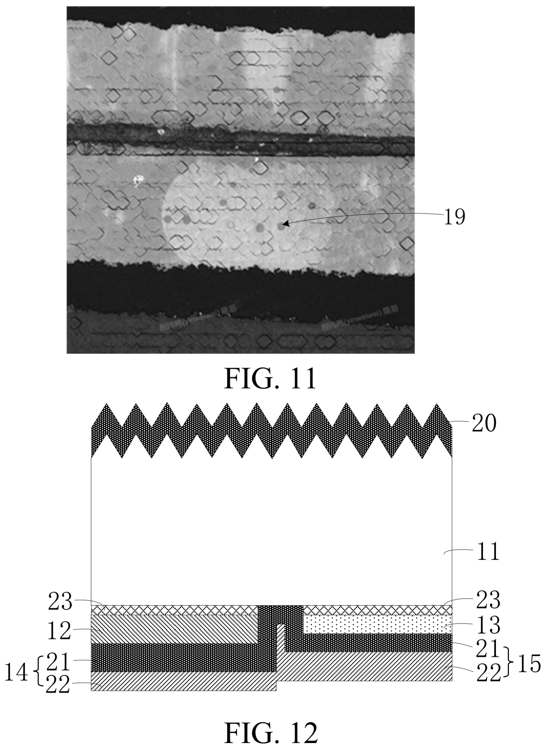

For example, as shown in FIG. 11, a bumpy anti-reflection structure 19 (for example, in the figure, a region having a slightly higher luminance) is formed at a position corresponding to the micro-structure 18 in the first doped semiconductor part 12 and/or the second doped semiconductor part 13. Specifically, when a local region of the first doped semiconductor part 12 has the micro-structure 18, the anti-reflection structure 19 may be formed at a position on the first doped semiconductor part 12 corresponding to the micro-structure 18; and/or when a local region of the second doped semiconductor part 13 has the micro-structure 18, the anti-reflection structure 19 may be formed at a position on the second doped semiconductor part 13 corresponding to the micro-structure 18. The foregoing anti-reflection structure 19 may affect the surface topography of the part, corresponding to the micro-structure 18, in the first doped semiconductor part 12 and/or the second doped semiconductor part 13 under pressing of hydrogen gas when hydrogen escapes from a corresponding passivation layer having the micro-structure 18. In this case, reduction of the reflectance of the side of the first doped semiconductor part 12 and/or the second doped semiconductor part 13 facing away from the semiconductor substrate 11 helps to refract more light into the semiconductor substrate 11 through the first doped semiconductor part 12 and/or the second doped semiconductor part 13, thereby improving the bifacial ratio of the solar cell. A specific topography of the foregoing anti-reflection structure 19 may be determined according to an actual manufacturing process, and is not specifically limited herein. For example, the anti-reflection structure 19 may be a pit structure whose surface is sunken into a corresponding doped semiconductor part.

Specific thicknesses of the first passivation sub-layer included in the first dielectric passivation layer and the first passivation sub-layer included in the second dielectric passivation layer may be determined according to material types of the first passivation sub-layer included in the first dielectric passivation layer and the first passivation sub-layer included in the second dielectric passivation layer, and requirements for field passivation and chemical passivation of the first dielectric passivation layer and requirements for chemical passivation of the second dielectric passivation layer in an actual application scenario, and are not specifically limited herein. In an embodiment, the thickness of the first passivation sub-layer included in the first dielectric passivation layer and the thickness of the first passivation sub-layer included in the second dielectric passivation layer may be selected from a range of 2 nm or more and 15 nm or less. Secondly, the first passivation sub-layer may be an aluminum oxide layer. In this case, the thickness of the aluminum oxide layer usually formed through atomic layer deposition is relatively uniform. However, because an aluminum oxide material may wrap around an edge of the solar cell, one or two points may be selected for testing at positions corresponding to the first doped semiconductor part and the second doped semiconductor part in the middle region of the solar cell, to compare the thicknesses of the aluminum oxide layers formed on the first doped semiconductor part and the second doped semiconductor part.

For example, the thickness of the first passivation sub-layer included in the first dielectric passivation layer may be greater than or equal to 4 nm and less than or equal to 15 nm. For example, the thickness of the first passivation sub-layer included in the first dielectric passivation layer may be 4 nm, 5 nm, 6 nm, 6.2 nm, 6.5 nm, 6.8 nm, 7 nm, 7.2 nm, 7.5 nm, 7.8 nm, 8 nm, 10 nm, 12 nm, or 15 nm. In this case, the relatively large thickness of the first passivation sub-layer included in the first dielectric passivation layer can further enhance a field passivation effect of the first passivation sub-layer included in the first dielectric passivation layer on the first doped semiconductor part, to help further reduce a differentiation degree between the part corresponding to the first doped semiconductor part and the part corresponding to the second doped semiconductor part in terms of a passivation effect on the side of the back surface of the back contact solar cell, thereby further improving the working performance of the back contact solar cell.

For example, the thickness of the first passivation sub-layer included in the second dielectric passivation layer may be greater than or equal to 2 nm and less than or equal to 8 nm. For example, the thickness of the first passivation sub-layer included in the second dielectric passivation layer may be 2 nm, 4 nm, 4.2 nm, 4.5 nm, 4.8 nm, 5 nm, 5.2 nm, 5.5 nm, 5.8 nm, 6 nm, 7 nm, or 8 nm. In this case, the thickness of the first passivation sub-layer included in the second dielectric passivation layer falls within the foregoing range, which helps avoid a case that a comprehensive passivation effect of the first passivation sub-layer included in the second dielectric passivation layer on the second doped semiconductor part is relatively low due to a relatively small thickness of the first passivation sub-layer included in the second dielectric passivation layer, to ensure that a side of the second doped semiconductor part facing away from the semiconductor substrate has relatively few surface defects; and further helps avoid a case that a degree by which the electric field of the second doped semiconductor part is weakened by the field passivation effect of the first passivation sub-layer included in the second dielectric passivation layer is relatively high because of a relatively large thickness of the first passivation sub-layer included in the second dielectric passivation layer, thereby ensuring a relatively high carrier collection efficiency of the second doped semiconductor part.

For the second passivation sub-layer included in the first dielectric passivation layer and the second passivation sub-layer included in the second dielectric passivation layer, in terms of materials, the material of the second passivation sub-layer included in the first dielectric passivation layer may be any passivation material different from that of the first passivation sub-layer included in the first dielectric passivation layer, and the second passivation sub-layer included in the first dielectric passivation layer may be a passivation layer having only a chemical passivation function, or may be a passivation layer having both a chemical passivation function and a field passivation function. Secondly, the material of the second passivation sub-layer included in the second dielectric passivation layer may be any passivation material different from that of the first passivation sub-layer included in the second dielectric passivation layer, and the first passivation sub-layer included in the second dielectric passivation layer may be a passivation layer having only a chemical passivation function, or may be a passivation layer having both a chemical passivation function and a field passivation function.

In addition, the material of the second passivation sub-layer included in the first dielectric passivation layer and the material of the second passivation sub-layer included in the second dielectric passivation layer may be the same or different. The case that the material of the second passivation sub-layer included in the first dielectric passivation layer is the same as the material of the second passivation sub-layer included in the second dielectric passivation layer helps to reduce types of materials used for manufacturing different structures of the back contact solar cell, improve compatibility between the different structures, and improve the yield of the back contact solar cell. Alternatively, the material of the second passivation sub-layer included in the first dielectric passivation layer may be different from a material of the second passivation sub-layer included in the second dielectric passivation layer.

Secondly, as shown in FIG. 5, the second passivation sub-layer 22 included in the first dielectric passivation layer 14 and the second passivation sub-layer 22 included in the second dielectric passivation layer 15 may alternatively be integrally continuous. In this case, the second passivation sub-layer 22 included in the first dielectric passivation layer 14 and the second passivation sub-layer 22 included in the second dielectric passivation layer 15 may be simultaneously formed based on a same material and in a same step, thereby improving manufacturing efficiency of the back contact solar cell, and facilitating reduction of manufacturing costs of the back contact solar cell.

In terms of thickness, the thickness of the second passivation sub-layer included in the first dielectric passivation layer and the thickness of the second passivation sub-layer included in the second dielectric passivation layer may be determined according to material types of the second passivation sub-layer included in the first dielectric passivation layer and the second passivation sub-layer included in the second dielectric passivation layer, and a requirement for a passivation effect of different second passivation sub-layers in an actual application scenario. This is not specifically limited herein.

For example, the thickness of the second passivation sub-layer included in the first dielectric passivation layer may be equal to the thickness of the second passivation sub-layer included in the second dielectric passivation layer. Alternatively, as shown in FIG. 4, the thickness of the second passivation sub-layer 22 included in the first dielectric passivation layer 14 may be less than the thickness of the second passivation sub-layer 22 included in the second dielectric passivation layer 15. In this case, the second passivation sub-layer 22 included in the second dielectric passivation layer 15 having a relatively large thickness (relative to the second passivation sub-layer 22 included in the first dielectric passivation layer 14) is disposed on the first passivation sub-layer 21 included in the second dielectric passivation layer 15 having a relatively small thickness (relative to the first passivation sub-layer 21 included in the first dielectric passivation layer 14), which helps compensate for, by using the second passivation sub-layer 22 included in the second dielectric passivation layer 15 having a relatively large thickness, weakening of the field passivation effect of the first passivation sub-layer 21 included in the second dielectric passivation layer 15 on the side of the second doped semiconductor part 13 facing away from the semiconductor substrate 11, thereby further reducing the quantity of surface defects on the side of the second doped semiconductor part 13 facing away from the semiconductor substrate 11, and helps reduce a differentiation between the part corresponding to the first doped semiconductor part 12 and the part corresponding to the second doped semiconductor part 13 in terms of a passivation effect on the side of the back surface of the back contact solar cell, thereby improving the working performance of the back contact solar cell.

In an actual manufacturing process, as shown in FIG. 5, when the thickness of the second passivation sub-layer 22 included in the first dielectric passivation layer 14 is less than the thickness of the second passivation sub-layer 22 included in the second dielectric passivation layer 15, and the second passivation sub-layer 22 included in the first dielectric passivation layer 14 and the second passivation sub-layer 22 included in the second dielectric passivation layer 15 are integrally continuous, deposition thicknesses of the second passivation sub-layer 22 included in the first dielectric passivation layer 14 and the second passivation sub-layer 22 included in the second dielectric passivation layer 15 may be different according to different doping concentrations of dopants in the first doped semiconductor part 12 and the second doped semiconductor part 13. For example, a description is provided by using an example in which each of the second passivation sub-layer 22 included in the first dielectric passivation layer 14 and the second passivation sub-layer 22 included in the second dielectric passivation layer 15 is a silicon nitride layer. When the doping concentration of a dopant in the first doped semiconductor part 12 is less than the doping concentration of a dopant in the second doped semiconductor part 13, and when the second passivation sub-layer 22 included in the first dielectric passivation layer 14 and the second passivation sub-layer 22 included in the second dielectric passivation layer 15 are simultaneously formed based on a same material and in a same step through a process such as plasma chemical vapor deposition, because electric field strengths corresponding to the first doped semiconductor part 12 and the second doped semiconductor part 13 are different, a thickness of the formed second passivation sub-layer 22 included in the first dielectric passivation layer 14 is relatively small, and a thickness of the formed second passivation sub-layer 22 included in the second dielectric passivation layer 15 is relatively large.

Certainly, the second passivation sub-layer included in the first dielectric passivation layer and the second passivation sub-layer included in the second dielectric passivation layer may alternatively be separately manufactured in different operation steps and by adjusting different manufacturing parameters, provided that the thickness of the second passivation sub-layer included in the first dielectric passivation layer is less than the thickness of the second passivation sub-layer included in the second dielectric passivation layer.

Specific thicknesses of the second passivation sub-layer included in the first dielectric passivation layer and the second passivation sub-layer included in the second dielectric passivation layer and a difference between the thicknesses may be determined according to a requirement for the PL luminance values of the parts corresponding to the first doped semiconductor part and the second doped semiconductor part on the side of the back surface of the back contact solar cell in an actual application scenario. This is not specifically limited herein.

For example, a difference between a thickness of the second passivation sub-layer included in the second dielectric passivation layer and a thickness of the second passivation sub-layer included in the first dielectric passivation layer may be greater than or equal to 0.5 nm and less than or equal to 5 nm. For example, the difference between the thickness of the second passivation sub-layer included in the second dielectric passivation layer and the thickness of the second passivation sub-layer included in the first dielectric passivation layer may be 0.5 nm, 0.7 nm, 0.9 nm, 1 nm, 2 nm, 3 nm, 4 nm, or 5 nm. In this case, that the difference between the thickness of the second passivation sub-layer included in the second dielectric passivation layer and the thickness of the second passivation sub-layer included in the first dielectric passivation layer falls within the foregoing range can avoid that because the difference is relatively small, the second passivation sub-layer included in the first dielectric passivation layer and the second passivation sub-layer included in the second dielectric passivation layer have approximately the same chemical passivation effect, thereby ensuring that the difference between the field passivation effects of the parts on the side of the back surface and respectively corresponding to the first doped semiconductor part and the second doped semiconductor part can be compensated for by using the second passivation sub-layer included in the second dielectric passivation layer; and can further avoid that because the difference is relatively large, the second passivation sub-layer included in the first dielectric passivation layer has an excessively low passivation effect due to an excessively small thickness of the second passivation sub-layer included in the first dielectric passivation layer, or a use amount of consumables is relatively high because of an excessively large thickness of the second passivation sub-layer included in the second dielectric passivation layer, thereby helping control manufacturing costs of the solar cell.

For example, a thickness of the second passivation sub-layer may be greater than or equal to 50 nm and less than or equal to 160 nm. For example, the thickness of the second passivation sub-layer may be 50 nm, 55 nm, 60 nm, 65 nm, 67 nm, 70 nm, 71 nm, 73 nm, 80 nm, 90 nm, 100 nm, 110 nm, 120 nm, 130 nm, 135 nm, 136 nm, 142 nm, 145 nm, 146 nm, 148 nm, 150 nm, 152 nm, 156 nm, 158 nm, or 160 nm. In this case, that the thickness of the second passivation sub-layer falls within the foregoing range helps avoid that the second passivation sub-layer has a relatively weak passivation effect because of a small thickness of the first passivation sub-layer, thereby ensuring a relatively low carrier recombination rate on the side of the back surface of the back contact solar cell, and improving the working performance of the back contact solar cell; and can further avoid that a use amount of consumables of the second passivation sub-layer is relatively large because of a large thickness of the second passivation sub-layer, thereby helping control manufacturing costs of the back contact solar cell. When the thickness of the second passivation sub-layer included in the first dielectric passivation layer is less than the thickness of the second passivation sub-layer included in the second dielectric passivation layer, specific values of the thicknesses of the second passivation sub-layers corresponding to the two doped semiconductor parts may be set according to an actual requirement and the foregoing description manner.

For example, the thickness of the first passivation sub-layer may be greater than or equal to 2 nm and less than or equal to 15 nm; and a thickness of the second passivation sub-layer may be greater than or equal to 50 nm and less than or equal to 160 nm. In this case, the first passivation sub-layer and the second passivation sub-layer are matched and used within the foregoing thickness ranges, so that the second passivation sub-layer can better match the difference between the two doped semiconductor parts caused by the field passivation effect brought by the first passivation sub-layer, thereby reducing the difference between the passivation effects of the two doped semiconductor parts.

For example, a ratio of a thickness of the first dielectric passivation layer to a thickness of the second dielectric passivation layer may be greater than or equal to 0.9 and less than or equal to 1.1; and/or a thickness of the first dielectric passivation layer and/or the second dielectric passivation layer may be greater than or equal to 52 nm and less than or equal to 175 nm.

For example, a ratio of a thickness of the first dielectric passivation layer to a thickness of the second dielectric passivation layer may be 0.9, 0.92, 0.95, 0.96, 1, 1.02, 1.05, 1.08, or 1.1.

For example, the thickness of the first dielectric passivation layer and/or the second dielectric passivation layer may be 52 nm, 55 nm, 60 nm, 70 nm, 75 nm, 80 nm, 90 nm, 100 nm, 110 nm, 120 nm, 130 nm, 140 nm, 150 nm, 160 nm, 165 nm, 170 nm, or 175 nm.

When the foregoing technical solution is used, when the ratio of the thickness of the first dielectric passivation layer to the thickness of the second dielectric passivation layer is greater than or equal to 0.9 and less than or equal to 1.1, the thickness of the first dielectric passivation layer disposed on the side of the first doped semiconductor part facing away from the semiconductor substrate is approximately the same as the thickness of the second dielectric passivation layer disposed on the side of the second doped semiconductor part facing away from the semiconductor substrate, which helps cause the first dielectric passivation layer and the second dielectric passivation layer to have approximately the same comprehensive passivation effect, thereby helping further reduce a differentiation between the part corresponding to the first doped semiconductor part and the part corresponding to the second doped semiconductor part in terms of a passivation effect on the side of the back surface of the back contact solar cell. In addition, when the thickness of the first dielectric passivation layer and/or the second dielectric passivation layer falls within the foregoing range, a moderate thickness of the first dielectric passivation layer and/or the second dielectric passivation layer avoids that a passivation effect of the first dielectric passivation layer and/or the second dielectric passivation layer is relatively weak due to a relatively small thickness value, and can further avoid that a distribution density of micro-structures in the first dielectric passivation layer and/or the second dielectric passivation layer is relatively large or a use amount of consumables is relatively high due to a relatively large thickness, thereby ensuring a relatively high operation efficiency of the back contact solar cell, and helping control manufacturing costs of the solar cell.

For the thicknesses of the first dielectric passivation layer and the second dielectric passivation layer, the thickness of the first dielectric passivation layer may be equal to the thickness of the second dielectric passivation layer. Alternatively, the thickness of the first dielectric passivation layer may be less than the thickness of the second dielectric passivation layer. Because the thickness of the first passivation sub-layer included in the first dielectric passivation layer is greater than the thickness of the second passivation sub-layer included in the second dielectric passivation layer, that the thickness of the first dielectric passivation layer is less than the thickness of the second dielectric passivation layer helps cause the thickness of the second passivation sub-layer included in the first dielectric passivation layer to be less than the thickness of the second passivation sub-layer included in the second dielectric passivation layer. Based on this, for an application principle of the beneficial effect that the thickness of the first dielectric passivation layer is less than the thickness of the second dielectric passivation layer, refer to the foregoing application principle of the beneficial effect that the thickness of the second passivation sub-layer included in the first dielectric passivation layer is less than the thickness of the second passivation sub-layer included in the second dielectric passivation layer. Details are not described herein again. In addition, a difference between the thicknesses of the first dielectric passivation layer and the second dielectric passivation layer may be determined according to a difference between the thicknesses of the first passivation sub-layer and the second passivation sub-layer that are included in the first dielectric passivation layer and the second dielectric passivation layer. This is not specifically limited herein.

In addition, the case that the thickness of the second passivation sub-layer included in the second dielectric passivation layer is greater than the thickness of the second passivation sub-layer included in the first dielectric passivation layer helps cause the thicknesses of the first dielectric passivation layer and the second dielectric passivation layer to be approximately the same, further helps cause the refractive index of the part corresponding to the first doped semiconductor part and the refractive index of the part corresponding to the second doped semiconductor part in the back surface of the back contact solar cell to be approximately the same, and helps implement uniform light absorption. Based on this, the thicknesses of the first dielectric passivation layer and the second dielectric passivation layer may also be determined according to a requirement for refractive indexes of different regions on a side of the back surface in an actual application scenario. For the back surface of the back contact solar cell, the values of the refractive indexes of the part corresponding to the first doped semiconductor part and the part corresponding to the second doped semiconductor part may be determined according to an actual requirement and material types of the first dielectric passivation layer and the second dielectric passivation layer.

For example, a ratio of a refractive index of the first dielectric passivation layer to a refractive index of the second dielectric passivation layer may be greater than or equal to 0.9 and less than or equal to 1.1; and/or a refractive index of the first dielectric passivation layer and/or the second dielectric passivation layer may be greater than or equal to 2.0 and less than or equal to 2.2.

For example, a ratio of the refractive index of the first dielectric passivation layer to the refractive index of the second dielectric passivation layer may be 0.9, 0.92, 0.95, 0.96, 1, 1.02, 1.05, 1.08, or 1.1.

For example, the refractive index of the first dielectric passivation layer and/or the second dielectric passivation layer may be 2.0, 2.01, 2.02, 2.03, 2.05, 2.08, 2.1, 2.12, 2.15, 2.18, or 2.2.

When the foregoing technical solution is used, when the ratio of the refractive index of the first dielectric passivation layer to the refractive index of the second dielectric passivation layer is greater than or equal to 0.9 and less than or equal to 1.1, the refractive index of the first dielectric passivation layer and the refractive index of the second dielectric passivation layer are approximately the same, which helps cause the part corresponding to the first dielectric passivation layer and the part corresponding to the second dielectric passivation layer on the side of the back surface of the back contact solar cell to have approximately the same light refracting function, to help achieve uniform light absorption and help ensure balance between electrons and holes. Secondly, when the refractive index of the first dielectric passivation layer and/or the second dielectric passivation layer falls within the foregoing range, the refractive index of the first dielectric passivation layer and/or the second dielectric passivation layer has a relatively high refracting effect on light, which helps cause more light to be set into the semiconductor substrate by using the refractive index of the first dielectric passivation layer and/or the second dielectric passivation layer, thereby improving a bifacial ratio of the solar cell.

For example, a difference between a refractive index of the second passivation sub-layer included in the second dielectric passivation layer and a refractive index of the second passivation sub-layer included in the first dielectric passivation layer may be greater than or equal to 0.01 and less than or equal to 0.1. For example, the difference between the refractive index of the second passivation sub-layer included in the second dielectric passivation layer and the refractive index of the second passivation sub-layer included in the first dielectric passivation layer may be 0.01, 0.02, 0.03, 0.05, 0.06, 0.08, or 0.1. For an application principle of a beneficial effect in this case, refer to the foregoing application principle of the beneficial effect that the first dielectric passivation layer and the second dielectric passivation layer have approximately the same refractive index. Details are not described herein again.

In an actual application process, the PL luminance value refers to luminance of light emitted by the solar cell under a lighting condition. The magnitude of the PL luminance value is related to passivation performance of a test part, and represents a comprehensive passivation effect of all film layers at a position corresponding to the first doped semiconductor part or at a position corresponding to the second doped semiconductor part, for example, a comprehensive passivation effect of tunneling passivation layers, doped semiconductor parts, and dielectric passivation layers. Specifically, under a same test condition, a larger PL luminance value indicates higher passivation performance of the part, and a smaller PL luminance value indicates lower passivation performance of the part. Based on this, a PL luminance value corresponding to a part corresponding to the second doped semiconductor part and a PL luminance value corresponding to a part corresponding to the first doped semiconductor part on a side of a back surface of the back contact solar cell under a same test condition may be determined according to a requirement for passivation effects of the first dielectric passivation layer and the second dielectric passivation layer in an actual application scenario. This is not specifically limited herein.

For example, under a same test condition, on a side of a back surface of the back contact solar cell, a PL luminance value corresponding to a part corresponding to the second doped semiconductor part 13 may be greater than a PL luminance value corresponding to a part corresponding to the first doped semiconductor part 12.

It should be noted that a condition for testing a PL luminance value is not specifically limited in this embodiment of the present application. A position for testing a PL luminance value may be on a finished solar cell. Specifically, corresponding film layers that are disposed around corresponding interconnection portions (for example, main grids or pad points) above the first doped semiconductor part and the second doped semiconductor part in the finished solar cell and that are located on an outermost side are separately selected for testing. For example, when the first dielectric passivation layer and the second dielectric passivation layer in the back contact solar cell are film layers on a side of the first surface that are disposed at an outermost side, partial regions, adjacent to corresponding interconnection portions, on sides of the first dielectric passivation layer and the second dielectric passivation layer that face away from the semiconductor substrate needs to be tested. Alternatively, a position for testing a PL luminance value may be on the foregoing corresponding film layer located at the outermost side after a conductive electrode in the finished solar cell is removed. Alternatively, special sample preparation may be performed on a PL luminance value in a manner of performing symmetric sample preparation on both faces of the solar cell. For example, a first doped semiconductor part and a first dielectric passivation layer on an entire face, or a second doped semiconductor part and a second dielectric passivation layer on an entire face are symmetrically disposed on two faces of the solar cell, and then a PL test is performed.

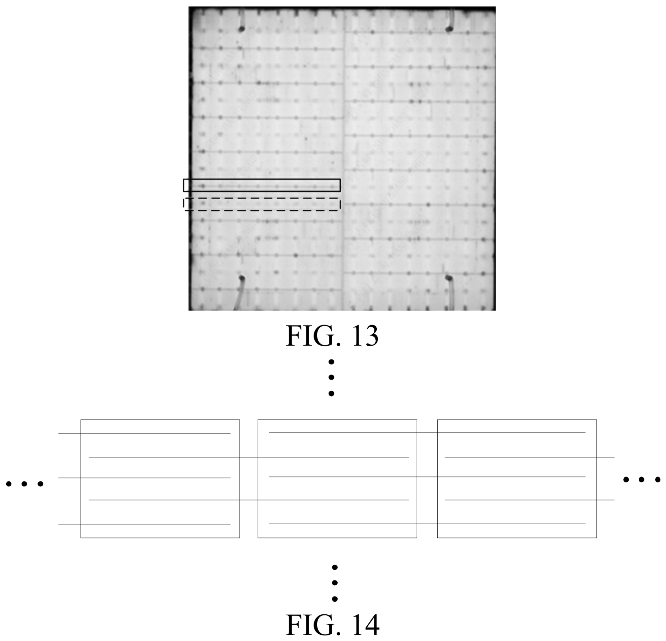

When the foregoing technical solution is used, when the PL luminance value corresponding to the part corresponding to the second doped semiconductor part is greater than the PL luminance value corresponding to the part corresponding to the first doped semiconductor part on the side of the back surface of the back contact solar cell, in the side of the back surface of the back contact solar cell provided in this embodiment of the present application, the passivation performance of the part corresponding to the second doped semiconductor part is higher than the passivation performance of the part corresponding to the first doped semiconductor part. In the foregoing case, additionally, the PL luminance values of the two regions reflect a combined effect of the field passivation and the chemical passivation, and can also indirectly reflect other passivation effects of film layers other than the first passivation sub-layer, that is, other passivation effects including that of the second dielectric passivation layer are greater than other passivation effects including that of the first dielectric passivation layer. A comprehensive passivation effect corresponding to the second doped semiconductor part is enhanced through passivation of other film layers, and a difference between the part corresponding to the first doped semiconductor part and the part corresponding to the second doped semiconductor part in terms of the passivation effect on the side of the back surface of the back contact solar cell is reduced. In addition, a passivation requirement for doped semiconductor parts of two different conductivity types is satisfied, so that each of a part corresponding to the first doped semiconductor part and a part corresponding to the second doped semiconductor part has a relatively low carrier recombination rate and a relatively high carrier separation capability on a side of a back surface of the back contact solar cell, thereby improving the working performance of the back contact solar cell. FIG. 13 is a test diagram of PL luminance of a finished structure of a back contact solar cell according to an embodiment of the present application. Bold solid lines and dashed lines respectively frame a region corresponding to the first doped semiconductor part and a region corresponding to the second doped semiconductor part. As can be seen from the accompanying drawing, PL luminance values of the two regions corresponding to a side of the back surface in the finished solar cell are approximately the same. In this case, passivation effects of the two regions corresponding to the side of the back surface in the finished solar cell are approximately the same.

In addition, it may be understood that, when the structure and the material of the first passivation sub-layer included in the first dielectric passivation layer are different from the structure and the material of the first passivation sub-layer included in the second dielectric passivation layer, passivation effects of the first passivation sub-layer included in the first dielectric passivation layer and the first passivation sub-layer included in the second dielectric passivation layer may be different, so that under a same test condition, on a side of a back surface of the back contact solar cell, a PL luminance value corresponding to a part corresponding to the second doped semiconductor part may also be different from a PL luminance value corresponding to a part corresponding to the first doped semiconductor part. Therefore, the PL luminance values corresponding to the foregoing two parts on the back surface may be determined according to the materials of the first passivation sub-layer included in the first dielectric passivation layer and the first passivation sub-layer included in the second dielectric passivation layer, and the structure of the back contact solar cell. This is not specifically limited herein.

For example, the first passivation sub-layer included in the first dielectric passivation layer is an aluminum oxide layer, and under a test condition in which an exposure time is 0.2s and a light intensity is 1 sun, a PL luminance value corresponding to the side of the first passivation sub-layer included in the first dielectric passivation layer that faces away from the semiconductor substrate may be greater than or equal to 5000. For example, when the first passivation sub-layer included in the first dielectric passivation layer is an aluminum oxide layer, and under a test condition in which an exposure time is 0.2s and a light intensity is 1 sun, a PL luminance value corresponding to the side of the first passivation sub-layer included in the first dielectric passivation layer that faces away from the semiconductor substrate may be 5000, 5500, 5800, 6000, 6500, 7000, 7500, 8000, or 9000. In this case, the aluminum oxide layer includes a large quantity of negative oxygen ions, and can form fixed negative charges with a relatively large density at an interface between the aluminum oxide layer and the first doped semiconductor part, to generate a built-in electric field having a function of shielding minority carriers, thereby improving the carrier collection efficiency of the first doped semiconductor part and enhancing the carrier separation capability of the first doped semiconductor part. Secondly, under the test condition in which the exposure time is 0.2s and the light intensity is 1 sun, when the PL luminance value corresponding to the side of the first passivation sub-layer included in the first dielectric passivation layer that faces away from the semiconductor substrate is greater than or equal to 5000, the existence of the first passivation sub-layer included in the first dielectric passivation layer having a relatively large thickness improves a field passivation effect on the first doped semiconductor part, to help further reduce a differentiation between the part corresponding to the first doped semiconductor part and the part corresponding to the second doped semiconductor part in terms of a passivation effect on the side of the back surface of the back contact solar cell.

For example, the first passivation sub-layer included in the second dielectric passivation layer is an aluminum oxide layer, and under a test condition in which an exposure time is 0.2s and a light intensity is 1 sun, a PL luminance value corresponding to the side of the first passivation sub-layer included in the second dielectric passivation layer that faces away from the semiconductor substrate may be greater than or equal to 16500. For example, the first passivation sub-layer included in the second dielectric passivation layer is an aluminum oxide layer, and under a test condition in which an exposure time is 0.2s and a light intensity is 1 sun, a PL luminance value corresponding to the side of the first passivation sub-layer included in the second dielectric passivation layer that faces away from the semiconductor substrate may be 16500, 16800, 17000, 18000, 20000, 22000, 24000, 28000, or 30000. In this case, by performing chemical passivation by using the first passivation sub-layer included in the second dielectric passivation layer, impact of a field passivation function of the first passivation sub-layer on the carrier collection efficiency of the second doped semiconductor part can be reduced as much as possible, to ensure that the second doped semiconductor part has a relatively high carrier separation capability, thereby helping further reduce a differentiation between the part corresponding to the first doped semiconductor part and the part corresponding to the second doped semiconductor part in terms of a passivation effect on the side of the back surface of the back contact solar cell.

For example, when each of the first passivation sub-layer included in the first dielectric passivation layer and the first passivation sub-layer included in the second dielectric passivation layer is an aluminum oxide layer (under a same test condition), a ratio of a PL luminance value corresponding to the side of the first passivation sub-layer included in the second dielectric passivation layer that faces away from the semiconductor substrate to a PL luminance value corresponding to the side of the first passivation sub-layer included in the first dielectric passivation layer that faces away from the semiconductor substrate may be greater than or equal to 2.5 and less than or equal to 3.4. For example, the foregoing ratio may be 2.5, 2.6, 2.7, 2.8, 2.9, 3.0, 3.1, 3.2, 3.3, or 3.4. In this case, compared with a ratio (which is roughly greater than or equal to 3 and less than or equal to 4) of the PL luminance value corresponding to the side of the second doped semiconductor part facing away from the semiconductor substrate to the PL luminance value corresponding to the side of the first doped semiconductor part facing away from the semiconductor substrate, when the ratio of the PL luminance value corresponding to the side of the first passivation sub-layer included in the second dielectric passivation layer that faces away from the semiconductor substrate to the PL luminance value corresponding to the side of the first passivation sub-layer included in the first dielectric passivation layer that faces away from the semiconductor substrate is greater than or equal to 2.5 and less than or equal to 3.4, the ratio between the foregoing PL luminance values is relatively small. That is, existence of the first passivation sub-layer included in the first dielectric passivation layer and the first passivation sub-layer included in the second dielectric passivation layer helps reduce a differentiation between the part corresponding to the first doped semiconductor part and the part corresponding to the second doped semiconductor part in terms of a passivation effect on the side of the back surface of the back contact solar cell, to help achieve uniform passivation.

In addition, it is defined that under the same test condition, a ratio of the PL luminance value corresponding to the side of the second dielectric passivation layer facing away from the semiconductor substrate to the PL luminance value corresponding to the side of the first dielectric passivation layer facing away from the semiconductor substrate is PL1. In addition, it is defined that under the same test condition, a ratio of the PL luminance value of the side of the fifth dielectric passivation layer facing away from the semiconductor substrate to the PL luminance value of the side of the fourth dielectric passivation layer facing away from the semiconductor substrate is PL2, and PL2 is less than PL1. In this case, the fourth passivation sub-layer and the fifth passivation sub-layer that have different thicknesses are set, to further reduce a differentiation between the part corresponding to the first doped semiconductor part and the part corresponding to the second doped semiconductor part in terms of a passivation effect on the side of the back surface of the back contact solar cell.

It may be understood that, when the structure and the material of the second passivation sub-layer included in the first dielectric passivation layer are different from the structure and the material of the second passivation sub-layer included in the second dielectric passivation layer, passivation effects of the second passivation sub-layer included in the first dielectric passivation layer and the second passivation sub-layer included in the second dielectric passivation layer may be different, so that under a same test condition, on a side of a back surface of the back contact solar cell, a PL luminance value corresponding to a part corresponding to the second doped semiconductor part may also be different from a PL luminance value corresponding to a part corresponding to the first doped semiconductor part. Therefore, the PL luminance values corresponding to the foregoing two parts on the back surface may be determined according to the materials of the second passivation sub-layer included in the first dielectric passivation layer and the second passivation sub-layer included in the second dielectric passivation layer, and the structure of the back contact solar cell. This is not specifically limited herein.

For example, when each of the second passivation sub-layer included in the first dielectric passivation layer and the second passivation sub-layer included in the second dielectric passivation layer is a silicon nitride layer, PL2 may be greater than or equal to 1.62 and less than or equal to 1.9. For example, PL2 may be 1.62, 1.65, 1.7, 1.75, 1.8, 1.85, or 1.9. In this case, when the second passivation sub-layer included in the first dielectric passivation layer and the second passivation sub-layer included in the second dielectric passivation layer are formed, the ratio between the PL luminance values of the part corresponding to the first doped semiconductor part and the part corresponding to the second doped semiconductor part on the side of the back surface of the solar cell can be further reduced, to reduce a differentiation degree in terms of passivation.

In an embodiment, under the test condition in which the exposure time is 0.2s and the light intensity is 1 sun, a PL luminance value corresponding to the part that is on the side of the back surface of the back contact solar cell and that corresponds to the first doped semiconductor part may be greater than or equal to 8000 and less than or equal to 25000.

In an embodiment, under the test condition in which the exposure time is 0.2s and the light intensity is 1 sun, a PL luminance value corresponding to the part that is on the side of the back surface of the back contact solar cell and that corresponds to the first doped semiconductor part may be greater than or equal to 20000 and less than or equal to 45000.

In a possible implementation solution, as shown in FIG. 12, the back contact solar cell may further include a third passivation layer 20 disposed on the second surface, and a thickness of the third passivation layer 20 is greater than a thickness of a part of the first passivation sub-layer 21 included in the first dielectric passivation layer 14. In this case, good chemical passivation is performed on a side of the second surface of the semiconductor substrate 11 by using the third passivation layer 20 having a relatively large thickness, to reduce the quantity of surface defects on the side of the second surface and a carrier recombination rate.

In this embodiment of the present application, a material and a thickness of the third passivation layer are not specifically limited, provided that the thickness of the third passivation layer is greater than the thickness of the first dielectric passivation layer. For example, the material of the third passivation layer may include at least one of aluminum oxide, silicon oxide, silicon nitride, and aluminum nitride.

In a second aspect, as shown in FIG. 14, an embodiment of the present application provides a photovoltaic module, including the back contact solar cell according to the first aspect and various implementations of the first aspect.

Specifically, because the type of the solar cell included in the photovoltaic module provided in this embodiment of the present application is a back contact solar cell, both positive and negative connection members for interconnecting different solar cells in the photovoltaic module are disposed on a side of a back surface of the solar cell. In addition, the photovoltaic module may include a transparent cover plate, a first encapsulating adhesive film, a back contact solar cell layer, a circuit interconnection layer, a second encapsulating adhesive film, and a back plate that are sequentially disposed.

The material of the transparent cover plate may include at least one of tempered glass, high-transparency plastic, and silicon rubber. The material of the first encapsulating adhesive film and the second encapsulating adhesive film may be POE, EVA, PVB, or another material. The back contact solar cell layer may include a plurality of back contact solar cells distributed in an array, and the plurality of back contact solar cells are connected by using the circuit interconnection layer. The foregoing circuit interconnection layer may implement an electrical connection between different back contact solar cells by using intra-string interconnection members such as soldering ribbons, or the foregoing circuit interconnection layer may be a conductive back plate. The conductive back plate includes a conductive circuit layer and an insulation material layer located between the conductive circuit layer and the back contact solar cell layer. A conductive window is disposed in the insulation material layer, and an interconnection structure of the back contact solar cell is interconnected to the pattered conductive circuit layer through the conductive window. As for the foregoing back plate, a material of the back plate may be TPC, PET, TPT, CPC, or another material, so as to prevent the circuit interconnection layer from reacting in an external environment and prolong the service life of the photovoltaic module.

For beneficial effects of the second aspect and various implementations of the second aspect in the embodiments of the present application, reference may be made to the analysis of the beneficial effects of the first aspect and various implementations of the first aspect, and details are not described herein.

In the foregoing description, technical details such as composition and etching of each layer are not described in detail. However, a person skilled in the art should understand that the layer, the region, and the like of a required shape may be formed by using various technical means. In addition, to form a same structure, a person skilled in the art may design a method that is not completely the same as the method described above. In addition, although the foregoing describes the embodiments separately, it does not mean that measures in the embodiments cannot be favorably combined.

The embodiments of the present application are described above. However, the embodiments are merely for more clear description and are not intended to limit a scope of the present application. Therefore, the scope of the present application is subject to the claims and equivalents thereof. A person skilled in the art may make various substitutes and modifications without departing from the scope of the present application, and the substitutes and modifications shall fall within the scope of the present application.

According to some embodiments, the present application further discloses a back contact solar cell, comprising: a semiconductor substrate, a first doped semiconductor part, a second doped semiconductor part, a first dielectric passivation layer, and a second dielectric passivation layer, where a conductivity type of the first doped semiconductor part is opposite to a conductivity type of the second doped semiconductor part; each of the first dielectric passivation layer and the second dielectric passivation layer includes a first passivation sub-layer having a field passivation function; and the conductivity type of the first doped semiconductor part is opposite to a conductivity type of fixed charges of the first passivation sub-layer;
the semiconductor substrate includes a first surface and a second surface opposite to each other; and along a direction parallel to the first surface, the first doped semiconductor part and the second doped semiconductor part are alternately distributed on the first surface;
the first dielectric passivation layer covers a side of the first doped semiconductor part facing away from the semiconductor substrate, and the second dielectric passivation layer covers a side of the second doped semiconductor part facing away from the semiconductor substrate; and
each of the first dielectric passivation layer and the second dielectric passivation layer further includes a second passivation sub-layer having a chemical passivation function; the second passivation sub-layer is disposed on a side of the first passivation sub-layer facing away from the semiconductor substrate; a material of the second passivation sub-layer included in the first dielectric passivation layer is different from a material of the first passivation sub-layer included in the first dielectric passivation layer; and a material of the second passivation sub-layer included in the second dielectric passivation layer is different from a material of the first passivation sub-layer included in the second dielectric passivation layer; and
the first passivation sub-layer included in the first dielectric passivation layer includes a hydrogen-containing passivation layer, and a local region of the hydrogen-containing passivation layer has a micro-structure.

According to some embodiments, the present application further discloses a back contact solar cell, where at least one micro-structure is a structure that is bulged in a direction away from the semiconductor substrate;
and/or at least one micro-structure is a micro-structure that is sunken or bulged in the middle and that has a cyclonic shape at an edge.

According to some embodiments, the present application further discloses a back contact solar cell, where the first passivation sub-layer included in the second dielectric passivation layer includes a hydrogen-containing passivation layer, and the hydrogen-containing passivation layer included in the second dielectric passivation layer is not provided with the micro-structure.

According to some embodiments, the present application further discloses a back contact solar cell, where when each of the first passivation sub-layer included in the first dielectric passivation layer and the first passivation sub-layer included in the second dielectric passivation layer includes the hydrogen-containing passivation layer,
a distribution density of the micro-structure in the first passivation sub-layer included in the first dielectric passivation layer is greater than a distribution density of the micro-structure in the first passivation sub-layer included in the second dielectric passivation layer.

According to some embodiments, the present application further discloses a back contact solar cell, where a size of the at least one micro-structure is greater than or equal to 10 µm and less than or equal to 20 µm;
and/or a height of the at least one micro-structure is greater than or equal to 0.1 µm and less than or equal to 0.5 µm.

According to some embodiments, the present application further discloses a back contact solar cell, where the thickness of the first passivation sub-layer is greater than or equal to 2 nm and less than or equal to 15 nm;
and/or a thickness of the first passivation sub-layer included in the first dielectric passivation layer is greater than a thickness of the first passivation sub-layer included in the second dielectric passivation layer; and
and/or an accommodating space that is formed by bulging exists between the hydrogen-containing passivation layer having the micro-structure and at least the first doped semiconductor part;
and/or an accommodating space that is formed by bulging exists between the first dielectric passivation layer and the first doped semiconductor part.

According to some embodiments, the present application further discloses a back contact solar cell, where a thickness of the second passivation sub-layer included in the first dielectric passivation layer is less than a thickness of the second passivation sub-layer included in the second dielectric passivation layer;
and/or a difference between a thickness of the second passivation sub-layer included in the second dielectric passivation layer and a thickness of the second passivation sub-layer included in the first dielectric passivation layer is greater than or equal to 0.5 nm and less than or equal to 5 nm;
and/or the back contact solar cell according to claim 1, wherein a thickness of the second passivation sub-layer is greater than or equal to 50 nm and less than or equal to 160 nm.

According to some embodiments, the present application further discloses a back contact solar cell, where a thickness of the first dielectric passivation layer is less than a thickness of the second dielectric passivation layer;
and/or a thickness of the first dielectric passivation layer and/or the second dielectric passivation layer is greater than or equal to 52 nm and less than or equal to 175 nm;
and/or under a same test condition, on a side of a back surface of the back contact solar cell, a PL luminance value corresponding to a part corresponding to the second doped semiconductor part is greater than a PL luminance value corresponding to a part corresponding to the first doped semiconductor part.

According to some embodiments, the present application further discloses a back contact solar cell, where a side surface of the first doped semiconductor part facing away from the semiconductor substrate has a first tower base-shaped texture structure, and a side surface of the second doped semiconductor part facing away from the semiconductor substrate has a second tower base-shaped texture structure; and
a one-dimensional size of the first tower base-shaped texture structure is different from a one-dimensional size of the second tower base-shaped texture structure.

According to some embodiments, the present application further discloses a back contact solar cell, where a side length of the first tower base-shaped texture structure is greater than a side length of the second tower base-shaped texture structure;
and/or a height of the first tower base-shaped texture structure is less than a height of the second tower base-shaped texture.

According to some embodiments, the present application further discloses a back contact solar cell, where the material of the first passivation sub-layer included in the first dielectric passivation layer is the same as the material of the first passivation sub-layer included in the second dielectric passivation layer;
and/or the first passivation sub-layer included in the first dielectric passivation layer and the first passivation sub-layer included in the second dielectric passivation layer are integrally continuous.

According to some embodiments, the present application further discloses a back contact solar cell, where the material of the second passivation sub-layer included in the first dielectric passivation layer is the same as the material of the second passivation sub-layer included in the second dielectric passivation layer;
and/or the second passivation sub-layer included in the first dielectric passivation layer and the second passivation sub-layer included in the second dielectric passivation layer are integrally continuous.

According to some embodiments, the present application further discloses a back contact solar cell, where a bumpy anti-reflection structure is formed at a position corresponding to the micro-structure in the first doped semiconductor part and/or the second doped semiconductor part.

The technical features in the foregoing embodiments may be combined arbitrarily, which is not limited in the present application.

According to some embodiments, the present application further discloses a photovoltaic module, comprising any back contact solar cell described above.

## Claims

1. A back contact solar cell, comprising: a semiconductor substrate, a first doped semiconductor part, a second doped semiconductor part, a first dielectric passivation layer, and a second dielectric passivation layer, wherein a conductivity type of the first doped semiconductor part is opposite to a conductivity type of the second doped semiconductor part ; each of the first dielectric passivation layer and the second dielectric passivation layer comprises a first passivation sub-layer having a field passivation function; and the conductivity type of the first doped semiconductor part is opposite to a conductivity type of fixed charges of the first passivation sub-layer ;
the semiconductor substrate comprises a first surface and a second surface opposite to each other; and along a direction parallel to the first surface, the first doped semiconductor part and the second doped semiconductor part are alternately distributed on the first surface;
the first dielectric passivation layer covers a side of the first doped semiconductor part facing away from the semiconductor substrate, and the second dielectric passivation layer covers a side of the second doped semiconductor part facing away from the semiconductor substrate ; and
each of the first dielectric passivation layer and the second dielectric passivation layer further comprises a second passivation sub-layer having a chemical passivation function; the second passivation sub-layer is disposed on a side of the first passivation sub-layer facing away from the semiconductor substrate ; a material of the second passivation sub-layer comprised in the first dielectric passivation layer is different from a material of the first passivation sub-layer comprised in the first dielectric passivation layer ; and a material of the second passivation sub-layer comprised in the second dielectric passivation layer is different from a material of the first passivation sub-layer comprised in the second dielectric passivation layer.

2. The back contact solar cell according to claim 1, wherein a thickness of the first passivation sub-layer comprised in the first dielectric passivation layer is greater than a thickness of the first passivation sub-layer comprised in the second dielectric passivation layer.

3. The back contact solar cell according to claim 1 or 2, wherein
the first passivation sub-layer comprised in the first dielectric passivation layer comprises a hydrogen-containing passivation layer, and a local region of the hydrogen-containing passivation layer has a micro-structure.

4. The back contact solar cell according to any one of claims 1 to 3, wherein a thickness of the second passivation sub-layer comprised in the first dielectric passivation layer is less than a thickness of the second passivation sub-layer comprised in the second dielectric passivation layer.

5. The back contact solar cell according to claim 1, wherein a difference between a thickness of the second passivation sub-layer comprised in the second dielectric passivation layer and a thickness of the second passivation sub-layer comprised in the first dielectric passivation layer is greater than or equal to 0.5 nm and less than or equal to 5 nm.

6. The back contact solar cell according to claim 1, wherein a thickness of the second passivation sub-layer is greater than or equal to 50 nm and less than or equal to 160 nm.

7. The back contact solar cell according to any one of claims 1 to 6, wherein a thickness of the first dielectric passivation layer is less than a thickness of the second dielectric passivation layer.

8. The back contact solar cell according to any one of claims 1 to 7, wherein a ratio of a thickness of the first dielectric passivation layer to a thickness of the second dielectric passivation layer is greater than or equal to 0.9 and less than or equal to 1.1.

9. The back contact solar cell according to any one of claims 1 to 8, wherein a thickness of the first dielectric passivation layer and/or the second dielectric passivation layer is greater than or equal to 52 nm and less than or equal to 175 nm.

10. The back contact solar cell according to any one of claims 1 to 9, wherein the first passivation sub-layer is an aluminum oxide layer, and under a test condition in which an exposure time is 0.2s and a light intensity is 1 sun,
a PL luminance value corresponding to the side of the first passivation sub-layer comprised in the first dielectric passivation layer that faces away from the semiconductor substrate is greater than or equal to 5000; and/or a PL luminance value corresponding to the side of the first passivation sub-layer comprised in the second dielectric passivation layer that faces away from the semiconductor substrate is greater than or equal to 16500.

11. The back contact solar cell according to any one of claims 1 to 10, wherein the first passivation sub-layer is an aluminum oxide layer, and under a test condition in which an exposure time is 0.2s and a light intensity is 1 sun, a ratio of a PL luminance value corresponding to the side of the first passivation sub-layer comprised in the second dielectric passivation layer that faces away from the semiconductor substrate to a PL luminance value corresponding to the side of the first passivation sub-layer comprised in the first dielectric passivation layer that faces away from the semiconductor substrate is greater than or equal to 2.5 and less than or equal to 3.4.

12. The back contact solar cell according to any one of claims 1 to 11, wherein a surface reflectance of the side of the first doped semiconductor part facing away from the semiconductor substrate is greater than a surface reflectance of the side of the second doped semiconductor part facing away from the semiconductor substrate.

13. The back contact solar cell according to claim 12, wherein a side of the first doped semiconductor part facing away from the semiconductor substrate has a first texture structure, and a side of the second doped semiconductor part facing away from the semiconductor substrate has a second texture structure ; and a one-dimensional size of the first texture structure is different from a one-dimensional size of the second texture structure.

14. The back contact solar cell according to any one of claims 1 to 13, wherein when the first doped semiconductor part is a P-type doped semiconductor part, and the second doped semiconductor part is an N-type doped semiconductor part,
a doping concentration of a dopant in the first doped semiconductor part is less than a doping concentration of a dopant in the second doped semiconductor part ; and/or a thickness of the first doped semiconductor part is greater than a thickness of the second doped semiconductor part.

15. A photovoltaic module, comprising the back contact solar cell according to any one of claims 1 to 14.
